# DEMANDE DE BREVET EUROPEEN

(11) **EP 4 557 347 A1**
(43) Date de publication de la demande: **21.05.2025**
(21) Numéro de dépôt: 24212824.7
(22) Date de dépôt: 13.11.2024
(51) Int. Cl.: H01L 21/20, H01L 21/768, H01L 23/00, H10D 88/00

(54) **DISPOSITIF MICROÉLECTRONIQUE OBTENU PAR INTÉGRATION 3D ET PROCÉDÉ DE RÉALISATION CORRESPONDANT**

(30) Priorité: 17.11.2023 FR 2312671
(71) Demandeur: Commissariat à l'Energie Atomique et aux Energies Alternatives, 75015 Paris (FR)
(72) Inventeur: RENAUD, Pablo, 38054 GRENOBLE CEDEX 09 (FR)
(74) Mandataire: INNOV-GROUP

(57) **Abrégé**

Une microstructure 3D est formée par collage d'une plaquette supérieure (1) sur une plaquette inférieure (2), par une liaison hybride avec des plots de liaison métalliques (17b,17c ; 27b,27c) à l'interface entre le niveau de métallisation supérieur (HBM) de la structure d'interconnexion respective de chacune des plaquettes. Ces structures d'interconnexion comprennent en outre un niveau d'interconnexion horizontale (MX) qui est directement en-dessous du niveau d'interconnexion supérieur (HBM). Ces plots sont répartis horizontalement de manière sensiblement homogène et avec un pas de collage fin. Parmi ces plots, des plots (17b ; 27b) de collage seulement sont isolés électriquement de tout élément de métallisation horizontale (15 ; 25) du niveau d'interconnexion horizontale (MX). Inversement, des plots (17c ; 27c) de collage et de raccordement électrique sont couplés électriquement, sans vias, à un élément de métallisation horizontale (15 ; 25) sous-jacent formé dans le niveau d'interconnexion horizontale (MX).

## Description

### DOMAINE TECHNIQUE

L'invention se rapporte de manière générale au domaine de l'industrie microélectronique ou industrie du semiconducteur. Elle concerne plus particulièrement l'intégration à trois dimensions (3D), par l'assemblage vertical de deux dispositifs microélectronique à deux dimensions (2D) formés chacun sur une plaque (« *Wafer* » en anglais) ou une puce (« *Die* » en anglais) à base de matériau semiconducteur respective, dit collage de type W2W (de l'anglais « *Wafer-to-Wafer* ») ou D2W (de l'anglais « *Die-to-Wafer* ») ou encore D2D (de l'anglais « *Die-to-Die* »), pour la réalisation d'un dispositif microélectronique 3D.

Plus spécifiquement, l'invention a pour objet une structure microélectronique 3D (ou microstructure 3D) obtenue par collage d'une première plaquette supérieure sur une plaquette inférieure avec une forte densité d'interconnexion entre lesdites plaquettes, ainsi qu'un procédé de réalisation d'une telle structure microélectronique 3D pour la fabrication d'un produit semiconducteur intégré.

Elle trouve des applications, notamment, dans la fabrication de microsystèmes et composants à densité d'intégration élevée, tels que des systèmes micro-électromécaniques (MEMS) ou nano-électromécaniques (NEMS), des actionneurs, des composants radiofréquences (RF), des dispositifs de puissance, ou des dispositifs microélectroniques comme des microprocesseurs avancés, des puces graphiques, des circuits optoélectroniques comme par exemple des capteurs d'image (ou imageurs) en technologie CMOS (de l'anglais « *Complementary Metal-Oxide-Semiconductor* »), ou autre.

### ÉTAT DE LA TECHNIQUE ANTÉRIEURE

Les dispositifs microélectroniques entrant dans la composition des produits semi-conducteurs intégrés dans un boîtier (ou circuits intégrés) sont réalisés par des étapes technologiques essentiellement planaires. Ces étapes sont exécutées sur des plaquettes ou galettes (« *wafer* » en anglais, qui se traduit littéralement par "tranche" en français) à base de matériau semiconducteur, comme le silicium dopé. Plus particulièrement, une succession d'étapes technologiques sont mises en oeuvre, à partir d'un substrat plan formant le support du dispositif, avec à chaque fois un accès à la microstructure en cours de réalisation par la face supérieure de la plaquette, dite aussi "face avant". La taille d'une plaquette est généralement d'environ 200 mm de diamètre en technologie 8" (*i.e.,* 8 pouces, ou « inch » en anglais) ou environ 300 mm de diamètre en technologie 12".

Une plaquette sur laquelle un dispositif microélectronique est réalisé comprend en effet un substrat sensiblement plan, avec une zone active dans la partie supérieure dudit substrat dans laquelle les composants actifs du dispositif sont réalisés, ainsi qu'une structure d'interconnexion multicouches formée au-dessus de ladite zone active du substrat pour raccorder les composants actifs préalablement formés, entre eux et avec les broches du circuit intégré. Le cas échéant, la structure d'interconnexion peut également intégrer des composants passifs (inductances, condensateurs, résistances, etc.) réalisés sous la forme d'éléments métalliques dans les couches d'interconnexion empilées.

La réalisation des composants actifs du dispositif dans la zone active du substrat correspond à la phase FEOL (de l'anglais « *Front-End-of Line* ») de la fabrication du dispositif. La réalisation de la structure d'interconnexion intervient quant à elle durant la phase BEOL (de l'anglais « *Back-End-of Line* »,) de la fabrication. La phase FEOL ne sera pas spécifiquement abordée ici, l'invention étant mise en oeuvre durant la phase BEOL.

La structure d'interconnexion comprend un empilement de couches d'interconnexion, réalisées en séquence avec alternance de couches d'interconnexion horizontale et de couches d'interconnexion verticale. Les premières comprennent des métallisations horizontales, c'est-à-dire des pistes métalliques qui s'étendent parallèlement au plan de la plaquette pour raccorder électriquement des éléments respectifs des composants actifs réalisés dans la zone active du substrat, et/ou le cas échéant des éléments métalliques formant les composants passifs précités. Les secondes comprennent des vias qui s'étendent perpendiculairement au plan de la plaquette afin de raccorder électriquement entre elles des pistes métalliques et/ou des composants passifs appartenant à des couches d'interconnexion horizontale respectives.

La formation d'une telle structure d'interconnexion par le procédé connu sous le nom de Damascène comprend successivement, pour chaque niveau d'interconnexion à réaliser en empilement :
- le dépôt d'une couche en matériau diélectrique sur la face supérieure du substrat du dispositif microélectronique, pour la première couche d'interconnexion, ou sur la face supérieure d'une couche d'interconnexion déjà réalisée, pour toute couche d'interconnexion suivant ladite première couche d'interconnexion ;
- la gravure, dans cette couche diélectrique, de tranchées (pour les couches d'interconnexion horizontale) ou de trous de passage de vias (pour les couches d'interconnexion verticale) ;
- le dépôt de cuivre (Cu) sur la couche diélectrique ainsi gravée, afin de remplir les tranchées et/ou les trous de passage de vias, pour obtenir les éléments métalliques d'interconnexion souhaités ; et,
- le polissage mécanochimique de l'excès de cuivre afin d'aplanir la surface supérieure de la couche d'interconnexion ainsi réalisée, en vue de la formation d'un autre niveau d'interconnexion par-dessus celui qui vient d'être réalisé.

Le collage de plaquettes désigne une technologie permettant d'assembler verticalement une première plaquette, appelée plaquette supérieure (ou « *top wafer* » en anglais), sur une autre plaquette ou plaquette inférieure (ou « *bottom wafer* » en anglais) aussi appelée plaquette "poignée" en référence à sa fonction de support de la microstructure ainsi obtenue. A cet effet, la première plaquette est retournée verticalement, puis est alignée et déposée par sa face avant sur la face avant de la plaquette poignée. Si une condition d'extrême planéité des surfaces supérieures des plaquettes respectives qui sont ainsi mises en contact est respectée, les forces de Van der Waals, à savoir des interactions d'attraction à l'échelle microscopique qui existent pour tous les matériaux, assurent l'adhésion entre les plaquettes inférieure et supérieure. Dans le domaine technique en cause, on parle de "collage" pour désigner un assemblage basé sur l'utilisation de ces forces d'adhésion. L'adhésion est d'autant plus forte que la surface de contact entre les deux plaques à l'échelle microscopique est grande, d'où l'importance de gommer toutes les aspérités de surface à cette échelle. Les surfaces supérieures des deux plaquettes correspondant à leurs faces avant respectives sont donc ultra-polies, préalablement à leur assemblage mutuel, afin d'être extrêmement lisses pour éviter tout défaut de collage.

Le collage de deux plaquettes ou plus, empilées verticalement, avec ou sans couche intermédiaire, permet la réalisation d'une microstructure 3D, alors même que seules des technologies de réalisation 2D sont séparément mises en oeuvre dans la phase FEOL (de l'anglais « *Front-End-of-Line* ») de la fabrication, pour réaliser les dispositifs microélectroniques dans chacune des deux plaquettes, respectivement. Différents protocoles technologiques (« *process flow* », en anglais) existent pour réaliser un tel assemblage 3D. Ces divers protocoles technologiques peuvent être différemment adaptés aux exigences spécifiques des applications visées, lesquelles sont multiples et variées. On se limitera ici aux solutions de collage hybride de plaquettes de matériau semiconducteur de type W2W, compatibles avec une liaison entre des plaquettes assemblées qui est à l'échelle de la plaquette (liaison dite « *wafer-level bonding* » en anglais).

La liaison entre les plaquettes empilées peut être assurée par l'intermédiaire, notamment, de plots de liaison (« *bonding pads* » en anglais) prévus à cet effet. Ces plots sont implantés en positions mutuelles respectives à la surface supérieure de chacune des deux plaquettes à assembler. En pratique, les plots de liaison sont des éléments en métal, qui sont réalisés dans le matériau diélectrique d'une couche d'interconnexion, par mise en oeuvre d'une ultime étape du procédé Damascène. De tels plots de liaison métalliques sont donc plus durs que le matériau diélectrique de la couche de matériau isolant dans laquelle ils sont réalisés.

Les plots de liaison sont plus particulièrement réalisés dans le dernier niveau de métallisation de chacune des plaquettes, i.e., le niveau de métallisation le plus élevé de la structure d'interconnexion de ladite plaquette, c'est-à-dire aussi le plus éloigné du substrat. Dans ce qui suit on l'appellera le niveau HBM (de l'anglais « *Hybrid Bonding Métal* »). La face supérieure des plots de liaison est donc exposée en surface de la structure d'interconnexion de chaque plaquette respective, qui est aussi la surface de la plaquette, à la fin de la phase BEOL de la fabrication.

Cette forme de réalisation des plots de liaison, en métal, est avantageuse pour diverses raisons qui sont liées, notamment, à la dureté du métal et aux étapes technologiques de la fabrication de tels plots métalliques. Ces raisons comprennent, notamment :
- la rigidité de la face supérieure de la plaquette ainsi obtenue (sous réserve d'une densité suffisante de plots métalliques) ;
- la précision des motifs (« *patterns* » en anglais) de réalisation des plots (par mise en oeuvre du procédé Damascène, qui est une technique efficace et mature) ;
- la qualité du polissage pouvant être obtenu par voie mécano-chimique conventionnelle (en raison notamment de la relative dureté du métal) ; et,
- la précision de l'alignement entre les plaquettes qui peut être obtenue en utilisant les plots métalliques pour le calage en positions relatives des deux plaquettes, etc.

Les plots de liaison étant réalisés en métal, et plus particulièrement en cuivre au sein d'une couche de matériau diélectrique par mise en oeuvre du procédé Damascène, ils sont donc par nature des éléments conducteurs du courant électrique. Le collage des plaquettes est dit "hybride" car l'interface de collage entre les plaquettes est hétérogène :
elle comprend des portions de métal correspondant aux plots de liaison, d'une part, et
des portions de matériau diélectrique correspondant aux zones entre lesdits plots,
d'autre part.

Un autre avantage de la réalisation de plots de liaison en métal est la possibilité de faire participer les plots de liaison au plan de routage (« *routing map* », en anglais) des signaux électriques de fonctionnement de la microstructure 3D finalement obtenue. Ce routage peut en effet être effectué en utilisant au moins certains des plots de liaison pour faire passer du courant entre la plaquette inférieure et la plaquette supérieure, et *vice versa,* de la microstructure 3D.

Parmi les plots de liaison, il y a alors :
- des plots de liaison d'un premier type, qui sont exclusivement dédiés au collage entre les plaquettes, et qui sont formés par des éléments de métallisation fictifs (connus par la personne de métier sous le terme anglais « *dummies* »). Ces plots ne sont connectés ni à des éléments du dispositif microélectronique réalisé dans la zone active de la plaquette, ni même à d'autres éléments passifs ou à des vias qui seraient réalisés dans les couches d'interconnexion horizontale ou verticale, respectivement, correspondant à des niveaux de métallisation inférieurs de la structure d'interconnexion. Dit autrement, ils sont parfaitement isolés électriquement d'autres éléments conducteurs appartenant à des dispositifs actifs ou passifs de la plaquette, par le matériau diélectrique qui les entoure. Ils n'assurent donc aucune fonction dans le fonctionnement du dispositif microélectronique final, au-delà de leur rôle basique de support de collage. On dira de ce fait qu'ils sont des plots de liaison non-fonctionnels ; ainsi que,
- des plots de liaison d'un second type qui, à la fois, servent de support de collage tout comme les plots du premier type ci-dessus, mais ont en outre pour rôle d'assurer aussi un raccordement électrique entre les deux plaquettes assemblées verticalement par ce collage. Ils participent de ce fait au fonctionnement du dispositif microélectronique final. Pour rendre ces plots de liaison ainsi fonctionnels, il est créé, pendant la phase BEOL de la réalisation des plaquettes individuelles (donc avant leur collage), des vias dans au moins la couche d'interconnexion verticale directement inférieure. Ces vias réalisent le raccordement électrique entre, d'un côté, les plots fonctionnels en question et, d'un autre côté, des éléments localisés en-dessous, par exemple des dispositifs actifs (comme des transistors ou des photodiodes, par exemple) réalisés pendant la phase FEOL dans la zone active de la plaquette correspondante, et/ou des dispositifs passifs (comme par exemple des pistes conductrices, des condensateurs, des inductances, etc.) réalisés pendant la phase BEOL, dans la couche d'interconnexion horizontale sous-jacente de la structure d'interconnexion de la plaquette correspondante. Les vias raccordant les plots de liaison du second type sont donc réalisés dans un niveau de métallisation dédié, qu'on appellera niveau HBV (de l'anglais « *Hybrid Bonding Vias* »)

En résumé, les plots de liaison du premier type (plots non-fonctionnels, ou "dummies") de chacune des deux plaquettes sont réalisés dans la dernière couche de métallisation de la structure d'interconnexion (*i.e*., la nième couche pour une structure d'interconnexion à *n* couches) correspondant au niveau de métallisation HBM, en étant isolés de tout élément sous-jacent de ladite plaquette par le matériau diélectrique de la pénultième couche de métallisation, qui est une couche d'interconnexion verticale correspondant au niveau de métallisation HBV ; alors que les plots de liaison du second type (plots fonctionnels) sont eux aussi réalisés dans la dernière couche de métallisation de la structure d'interconnexion mais sont couplés à des éléments actifs de la zone active du substrat ou à des éléments passifs de l'antépénultième couche de la structure d'interconnexion (qui est une couche d'interconnexion horizontale) par des vias réalisés dans la pénultième couche de ladite structure (qui est une couche d'interconnexion verticale correspondant au niveau de métallisation HBV).

Par ailleurs, le nombre de plots de liaison par unité de surface (y-inclus les plots de collage non-fonctionnels, d'une part, et les plots de collage et de raccordement qui sont fonctionnels, d'autre part), ainsi que leurs positions respectives à la surface supérieure des plaques, sont dictés par des contraintes de fabrication et de fiabilité des dispositifs microélectroniques. Ces contraintes sont définies dans un manuel des règles de dessin, ou DRM (de l'anglais « *Design Rules Manual* »). Le respect de telles contraintes de dessin (« *design* », en anglais) permet l'élaboration de circuits intégrés fabricables, fonctionnels et fiables, avec un budget énergétique le plus bas possible et une compétitivité économique la meilleure possible.

Selon ces règles de dessin, il faut une densité minimale de plots de liaison et une répartition à peu près homogène desdits plots de liaison sur la face supérieure des plaquettes à coller. Ceci permet d'obtenir, par polissage mécanochimique ou CMP (de l'anglais « *Chemical Mechanical Polishing* »), une surface supérieure des plaquettes à assembler verticalement qui soit suffisamment plane pour réaliser une microstructure 3D sans défauts de collage. En cas de non-respect de ces règles de dessin, il est difficile d'obtenir des plaquettes avec une surface supérieure bien plane. En effet, le polissage par CMP génère des différences de topographie entre les zones plus ou moins denses en métal suivant la saumure de CMP (« *CMP slurry* » en anglais) qui est utilisée (phénomène d'érosion). Ces zones érodées apparaissent alors comme des creux sur la surface et ne sont donc pas collées lors du collage. Ces défauts de surface se matérialisent donc par des zones non collées, i.e., des bulles d'interface appelées "vides" (« *voids* » en anglais). Ces vides fragilisent la microstructure 3D et rendent non-fonctionnelles les puces concernées par de tels défauts de collage (car le contact électrique n'est plus assuré).

Le pas de collage (ou « *bonding pitch* » en anglais) définit la limite haute de l'espacement des plots de liaison dans le plan horizontal XY de la plaquette, c'est-à-dire la distance maximale centre-à-centre entre les plots de liaison adjacents les plus proches dans ledit plan horizontal XY. Il s'agit d'un des paramètres du DRM à respecter lors de la conception du circuit intégré. Plus le pas de collage est fin, plus la densité d'interconnexion est élevée, et inversement. L'invention s'applique en particulier à des réalisations avec collage hybride de plaquettes à forte densité d'interconnexions, i.e., avec un pas de collage fin, c'est-à-dire qui est inférieur à 10 micromètres (µm), par exemple de l'ordre de 5 µm.

Dans l'art existant exposé plus haut, la différentiation entre des plots de liaison fonctionnels et des plots de liaison non-fonctionnels résulte de la formation sélective, avant le collage hybride, de vias dans la couche d'interconnexion verticale correspondant au niveau de métallisation dit "HBV", directement en dessous de la dernière couche de la structure d'interconnexion correspondant au niveau de métallisation dit "HBM" et dans laquelle lesdits plots de liaison sont réalisés en respectant les prescriptions du DRM relatives à la forte densité d'interconnexion. Cette avant-dernière couche HBV est une couche de métallisation verticale qui est réalisée à cette unique fin dans la structure d'interconnexion de chacune des plaquettes à assembler verticalement.

L'article scientifique Kim et al., « Multi-Stack Wafer Bonding Démonstration Utilizing Cu to Cu Hybrid Bonding and TSV Enabling Diverse 3D Integration », IEEE 71st Electronic Components and Technology Conférence (ECTC) - 2021, divulgue une intégration par empilement vertical de trois plaquettes avec, dans cet ordre : une plaquette inférieure, une plaquette intermédiaire, et une plaquette supérieure. Contrairement à ce qui est décrit pour la liaison entre la plaquette intermédiaire et la plaquette inférieure, la liaison entre la plaquette supérieure et la plaquette intermédiaire est réalisée sans via, au sens habituel de ce terme. Dit autrement, ni dans la structure d'interconnexion de la plaquette supérieure ni dans celle de la plaquette intermédiaire prévue pour être interconnectée avec ladite plaquette supérieure, il n'y a de via entre des plots métalliques de liaison réalisés dans ces structures d'interconnexion d'un côté, et des éléments (actifs ou passifs) réalisés dans des niveaux de métallisation inférieurs de la plaquette concernée, d'un autre côté. Les plots de liaison de la plaquette intermédiaire et de la plaquette supérieure qui sont divulgués dans ce document sont tous des plots de raccordement électrique entre ladite plaquette intermédiaire et ladite plaquette supérieure, i.e., des plots de liaison fonctionnels, et qui sont utilisés, en outre, comme plots de collage. En fait, tout se passe comme si les plots de liaison avaient tous la fonction de plots de raccordement électrique (c'est-à-dire la fonction basique d'un via, en réalité, mais à l'interface entre les deux plaquettes empilées), en étant mis en contact électrique deux-à-deux par l'effet du collage vertical entre les deux plaquettes.

Toutefois, cette intégration n'est pas compatible avec les règles de dessin telles que celles qui sont imposées par la CMP pour des applications en collage hybride, et qui ont été présentées plus haut. Notamment, le document Kim et al. 2021 n'adresse pas la problématique de la taille du pas de collage dans l'intégration considérée. Par exemple, il ne divulgue pas que des plots de collage devraient être en nombre minimum par unité de surface et/ou devraient respecter une certaine topologie d'implantation (i.e., une répartition spatiale) particulière à la surface supérieure des dispositifs semiconducteurs correspondant à la plaque supérieure et à la plaque intermédiaire. Ainsi, la fonction de support de collage assurée par les vias comme divulgué dans ce document ne semble pas être liée à des considérations morphologiques particulières relatives à des contraintes d'implantation de plots de collage. Au contraire le document Kim et al. 2021 enseigne simplement d'utiliser les vias qui sont prévus en première intention pour le raccordement électrique entre les plaquettes, comme support de collage hybride ce qui en fait des plots de liaison fonctionnels. Mais rien n'est indiqué dans le document qui suggérerait l'existence de plots de collage non-fonctionnels. Or, il apparaît que le type d'intégration décrit n'est pas viable pour des pas de collage fins (i.e., de l'ordre de 5 µm) ou même standards (i.e., jusqu'à 10 µm). En effet, pour les microstructures à forte densité d'interconnexion, les plots de collage ne peuvent en pratique se limiter à des plots de liaison fonctionnels dont le nombre, l'emplacement et la répartition ne sont dictés que par le plan de routage, sans adresser les impératifs du DRM relativement à la densité d'interconnexion entre les plaquettes.

Aussi, ce type d'intégration dépourvu d'une couche de la structure d'interconnexion dédiée à la formation de vias de liaison qui ne soient pas également des plots de raccordement électrique (c'est-à-dire une intégration verticale sans plots "dummies"), n'est envisageable que si on peut n'utiliser pour le collage hybride que des plots déjà prévus pour assurer une fonction de raccordement électrique dans la microstructure 3D considérée. En pratique, cette solution peut éventuellement trouver des applications dans des structures de test simples (ou « *daisy chains* », en anglais) seulement, pour des applications de laboratoire dans lesquelles le risque de défauts de collage est acceptable. Mais elle n'est pas utilisable dans le cas de l'intégration d'une microstructure 3D, pour la fabrication de circuits intégrés à l'échelle industrielle destinés à des applications commerciales. Dans ce cas en effet, le manuel des règles de dessin (DRM) impose une densité minimale et une répartition sensiblement homogène de plots de collage, qui visent à assurer une densité d'interconnexion suffisante pour éviter les défauts de collage. Une telle densité et une telle répartition ne se rencontre pas en général lorsque les plots de collage sont formés exclusivement de plots de liaison fonctionnels prévus pour d'autres raisons, à savoir des raisons liées au plan de routage du dispositif microélectronique 3D.

Le document US2021035941A1 divulgue un dispositif à semi-conducteur comprenant une première structure semi-conductrice et une seconde structure semi-conductrice séparées par une interface de collage. Chaque structure semi-conductrice a une couche d'interconnexion, ainsi qu'une couche de liaison ayant des contacts de liaison pour la liaison avec l'autre structure semi-conductrice. Ce document adresse la question de la qualité du collage, et notamment en lien avec la densité de contacts de liaison assurant le collage entre les deux structures semi-conductrices. Certains des contacts de liaison de la première structure semi-conductrice sont dits "fonctionnels" car ils participent à une connexion électrique à travers l'interface de liaison entre les deux structures. D'autres sont des contacts de liaison fictifs. Toutefois, il enseigne que, pour la première structure semi-conductrice, il y a des zones sans contacts de liaison en raison du fait que ces contacts sont formés avec arrêt sur des interconnexions et qu'il y a des zones de la couche d'interconnexion qui en sont dépourvues.

Le document US2021327789A1 divulgue également la fabrication d'une structure par collage hybride de deux puces, avec coexistence de connecteurs de raccordement électrique couplés entre eux, d'une part, et de connecteurs fictifs couplés entre eux, d'autre part. Toutefois, la qualité du collage hybride n'est pas évoquée dans son rapport avec la fonction technique des connecteurs fictifs.

Le document US10141391B2 divulgue une structure semi-conductrice tridimensionnelle (3D) dans laquelle une première couche d'oxyde de liaison d'une première structure semi-conductrice est liée à une deuxième couche d'oxyde de liaison d'une deuxième structure semi-conductrice. Des interfaces de collage existent entre des plots métalliques sont fictifs, en ce sens qu'ils sont isolés des structures d'interconnexion de chaque puce. Toutefois, ce document n'évoque pas la problématique de la densité des plots de collage.

### EXPOSÉ DE L'INVENTION

L'invention a pour objectif de proposer une alternative à l'art existant exposé dans ce qui précède, permettant de se passer de la couche HBV tout en respectant les prescriptions du DRM relativement à la densité et à la l'homogénéité de la répartition de plots de liaison.

Pour cela, l'invention a pour premier objet une structure microélectronique à trois dimensions, 3D, pour un produit semi-conducteur intégré, ladite structure microélectronique 3D comportant un premier dispositif microélectronique réalisé sur une plaquette supérieure, ainsi qu'un second dispositif microélectronique réalisé sur une plaquette inférieure sur laquelle la plaquette supérieure est collée par collage hybride après retournement vertical, dans laquelle la plaquette inférieure et la plaquette supérieure comprennent chacune un substrat sensiblement plan ainsi qu'une structure d'interconnexion formée au-dessus dudit substrat, dans laquelle :
- la structure d'interconnexion respective de chacune des plaquettes supérieure et inférieure est un empilement vertical d'au moins deux niveaux d'interconnexion directement superposés et comprenant chacun une couche hybride essentiellement composée d'un matériau diélectrique, à savoir, respectivement :
   ∘ un niveau d'interconnexion supérieur (HBM), avec des plots de liaison métalliques formés dans le matériau diélectrique et adaptés pour coopérer avec des plots de liaison métalliques correspondants de l'autre plaquette pour le collage hybride de la plaquette supérieure sur la plaquette inférieure; et,
   ∘ un niveau d'interconnexion horizontale (MX) qui est directement en-dessous du niveau d'interconnexion supérieur, avec des éléments de métallisation horizontales,
- les plots de liaison métalliques respectifs de chacune des plaquettes supérieure et inférieure sont répartis de manière sensiblement homogène à la surface supérieure du niveau d'interconnexion supérieur de la structure d'interconnexion de ladite plaquette, avec un pas de collage, défini comme l'espacement maximum entre des plots de liaison adjacents horizontalement dans le plan de ladite surface supérieure, qui est inférieur à un seuil associé déterminé ;
- les plots de liaison métalliques respectifs de chacune des plaquettes supérieure et inférieure comprennent des plots de liaison d'un premier type, qui sont isolés électriquement de tout élément de métallisation horizontale du niveau d'interconnexion horizontale de la structure d'interconnexion de ladite plaquette ; et,
- les plots de liaison métalliques respectifs de chacune des plaquettes supérieure et inférieure comprennent en outre des plots de liaison d'un second type, qui sont couplés électriquement chacun à au moins un élément de métallisation horizontale sous-jacent formé dans le niveau d'interconnexion horizontale de la structure d'interconnexion de ladite plaquette.

Comme la personne du métier l'aura compris, le premier dispositif microélectronique formé sur la plaquette supérieure et le second dispositif microélectronique formé sur la plaquette inférieure sont assemblés verticalement l'un au-dessus de l'autre par collage hybride pleine plaque, par l'intermédiaire d'une liaison hybride à l'interface entre la couche supérieure de la structure d'interconnexion respective de chacune desdites plaquettes supérieure et inférieure.

Certains aspects préférés mais non limitatifs du procédé sont les suivants.

Le niveau d'interconnexion horizontale de la structure d'interconnexion de chacune des plaquettes inférieure et supérieure peut comprendre un film de passivation en matériau électriquement isolant qui recouvre la couche en matériau diélectrique dudit niveau de métallisation horizontale, les plots de liaison du premier type de chacune des plaquettes supérieure et inférieure étant isolés électriquement de tout élément de métallisation horizontale du niveau d'interconnexion horizontale de la structure d'interconnexion de ladite plaquette, au moins par le matériau isolant du film de passivation recouvrant la couche en matériau diélectrique dudit niveau de métallisation horizontale.

La couche de matériau diélectrique du niveau d'interconnexion supérieur de la structure d'interconnexion de chacune des plaquettes supérieure et inférieure peut être une couche hybride de matériau diélectrique à motifs, lesdits motifs définissant :
- des zones pleines dudit matériau diélectrique ;
- des premières zones traversantes verticalement emplies de matériau métallique et au niveau desquelles le matériau isolant de la couche de passivation du niveau d'interconnexion horizontale est présent, lesdites premières zones traversantes formant les plots de liaison du premier type du niveau d'interconnexion supérieur ; et,
- des secondes zones traversantes verticalement, emplies de matériau métallique, et au niveau desquelles la couche de passivation du niveau d'interconnexion horizontale présente une ouverture, lesdites secondes zones traversantes formant les plots de liaison du second type du niveau d'interconnexion supérieur, chacun en continuité électrique avec l'un des éléments de métallisation horizontale du niveau d'interconnexion horizontale à travers ladite ouverture de la couche de passivation.

Dans des modes de réalisation, le seuil associé du pas de collage est inférieur ou égal à 10 µm, de préférence de l'ordre de 5 µm.

Le matériau diélectrique des couches hybrides d'interconnexion de la structure d'interconnexion de chacune des plaquettes supérieure et inférieure est par exemple du Dioxyde de Silicium (SiO2).

Le matériau constitutif des plots de liaison métalliques du niveau d'interconnexion supérieur et/ou le matériau constitutif des métallisations horizontales du niveau d'interconnexion horizontale de la structure d'interconnexion de chacune des plaquettes supérieure et inférieure, peut être un métal sélectionné dans le groupe comprenant le cuivre (Cu), l'or (Au), le titane (Ti), l'aluminium (Al), le niobium (Nb) et le platine (Pt), ou un alliage à base de l'un au moins desdits métaux.

Dans des modes de réalisation, le matériau électriquement isolant du film de passivation du niveau d'interconnexion horizontale de la structure d'interconnexion de chacune des plaquettes supérieure et inférieure est un nitrure de Silicium (SiN) ou un carbonitrure de silicium (SiCN).

Le substrat de la plaquette supérieure et/ou le substrat de la plaquette inférieure peuvent comprendre chacun une zone active avec des éléments actifs dans la partie supérieure dudit substrat, et dans laquelle :
- les plots de liaison du premier type de la structure d'interconnexion de chacune des plaquettes supérieure et inférieure sont électriquement isolés des éléments actifs de la zone active du substrat de ladite plaquette, alors que,
- certains au moins des plots de liaison du second type de la structure d'interconnexion de la plaquette supérieure et/ou de la plaquette inférieure sont couplés électriquement à au moins l'un des éléments actifs de la zone active du substrat de ladite plaquette.

L'invention a aussi pour objet un procédé de réalisation d'une structure microélectronique à trois dimensions, 3D, selon le premier aspect ci-dessus, comprenant le collage hybride d'une plaquette supérieure sur une plaquette inférieure après retournement vertical de ladite plaquette supérieure, dans lequel la réalisation préalable de la structure d'interconnexion de chacune des plaquettes inférieure et supérieure comprend la formation d'un empilement vertical d'au moins deux niveaux d'interconnexion directement superposés au-dessus du substrat de ladite plaquette, à savoir, respectivement :
- un niveau d'interconnexion horizontale (MX), avec des éléments de métallisation horizontale formés dans le matériau diélectrique d'une couche hybride correspondante ; et, directement au-dessus dudit niveau d'interconnexion horizontale (MX),
- un niveau d'interconnexion supérieur (HBM) avec des plots de liaison métalliques formés dans le matériau diélectrique d'une couche hybride correspondante, et adaptés pour coopérer avec des plots de liaison métalliques correspondants de l'autre plaquette, pour le collage hybride de la plaquette supérieure (1) sur la plaquette inférieure,
et dans lequel :
- les plots de liaison métalliques respectifs du niveau de métallisation supérieur de la structure d'interconnexion de chacune des plaquettes supérieure et inférieure sont réalisés avec une répartition sensiblement homogène à la surface supérieure dudit niveau de métallisation supérieur, et avec un pas de collage, défini comme l'espacement maximum entre des plots de liaison adjacents horizontalement dans le plan de ladite surface supérieure, qui est inférieur à un seuil associé déterminé ;
- parmi les plots de liaison métalliques respectifs de chacune des plaquettes supérieure et inférieure, des plots de liaison d'un premier type sont réalisés chacun avec isolation électrique vis-à-vis de tout élément de métallisation horizontale du niveau d'interconnexion horizontale de la structure d'interconnexion de ladite plaquette ;
- parmi les plots de liaison respectifs de chacune des plaquettes supérieure et inférieure, en outre, des plots de liaison d'un second type sont réalisés chacun en continuité électrique avec au moins un élément de métallisation horizontale sous-jacent formé dans le niveau d'interconnexion horizontale de la structure d'interconnexion de ladite plaquette.

Dans des modes de mise en oeuvre du procédé, la formation du niveau d'interconnexion supérieur de la structure d'interconnexion de chacune des plaquettes supérieure et inférieure peut comprendre :
- le dépôt d'un film de passivation en matériau électriquement isolant qui recouvre une couche hybride en matériau diélectrique comprenant des éléments de métallisation horizontale du niveau de métallisation horizontale de la plaquette ;
- la formation d'une couche en matériau diélectrique ainsi qu'une première gravure par photolithographie, pour graver ladite couche en matériau diélectrique avec arrêt sur le film de passivation du niveau de métallisation horizontale afin de former des motifs dans ladite couche en matériau diélectrique correspondant aux plots de liaison métalliques du niveau de métallisation supérieur de la plaquette ; puis,
- une seconde gravure par photolithographie, pour graver le film de passivation du niveau de métallisation horizontale afin d'ouvrir ledit film dans une partie seulement des motifs précédemment formés dans la couche en matériau diélectrique qui correspondent aux plots de liaison métalliques du second type du niveau de métallisation supérieur de la plaquette ; puis,
- le remplissage, avec du métal, simultanément de tous les motifs précédemment formés dans la couche en matériau diélectrique, à savoir aussi bien les motifs correspondant aux plots de liaison métalliques du premier type que les motifs correspondant aux plots de liaison métalliques du second type du niveau de métallisation supérieur de la plaquette.

Les motifs dans la couche en matériau diélectrique correspondant aux plots de liaison métalliques du niveau de métallisation supérieur de la plaquette peuvent, par exemple, être remplis de métal par dépôt électrochimique.

Ainsi, les plots de liaison du premier type de chaque plaquette sont formés dans la couche supérieure de la structure d'interconnexion et sont isolés électriquement de tout élément de métallisation formé dans toute couche d'interconnexion correspondant à un niveau de métallisation plus bas dans l'empilement de couches formant la structure d'interconnexion, ainsi que de tout élément actif de la zone active de la plaquette inférieure. Cette isolation est procurée, par le matériau isolant de la couche de passivation associée à la couche d'interconnexion horizontale de la structure d'interconnexion qui est directement en-dessous de ladite couche supérieure. Ces plots de liaison du premier type sont donc des plots non-fonctionnels, i.e., des métallisations fictives ("dummies"), qui ne servent qu'au collage hybride seulement.

Par contre, les plots de liaison du second type sont des plots de collage et de raccordement électrique formés dans la couche supérieure de la structure d'interconnexion, en continuité électrique avec un élément métallique d'au moins une autre couche d'interconnexion horizontale de la structure d'interconnexion qui est la couche de métallisation directement en-dessous de la couche supérieure. Ces plots de liaison du second type sont donc des plots fonctionnels, servant à la fois au collage hybride de la plaquette supérieure retournée verticalement sur la plaquette inférieure, et au raccordement électrique entre les deux dispositifs ainsi assemblés verticalement.

La réalisation du produit semiconducteur conforme au premier aspect de l'invention ci-dessus, et la mise en oeuvre du procédé conforme au second aspect de l'invention ci-dessus, rendent inutile la réalisation d'une couche d'interconnexion verticale avec des vias directement en-dessous de la couche supérieure de chacun des deux dispositifs microélectroniques 2D à empiler. On peut donc se passer de cette réalisation, en ayant des plots de liaison fonctionnels comme des plots de liaison non-fonctionnels qui permettent, ensemble, d'atteindre la densité d'interconnexion désirée. On peut ainsi respecter les règles de dessins (DRM) pour obtenir de bonnes performances de CMP et donc un collage de bonne qualité des deux dispositifs microélectroniques empilés.

Selon un autre avantage, la résistance électrique d'un plot de liaison fonctionnel réalisé conformément à des modes de mise en oeuvre du procédé proposé est significativement plus faible que celle des connections électriques verticales réalisées par des vias selon l'art existant. La réduction de la résistance d'interconnexion réduit la dissipation d'énergie par effet Joule dans le circuit intégré en fonctionnement, et donc limite l'élévation de la température. Cette réduction améliore aussi l'autonomie des petits appareils portatifs (comme les smartphones) incorporant le circuit intégré, lorsqu'ils fonctionnent sur batterie.

On rappelle en effet que la résistance électrique d'une interconnexion est inversement proportionnelle à la surface de contact entre les deux éléments d'interconnexion mis en contact électrique l'un avec l'autre, toutes choses étant égales par ailleurs : plus cette surface est grande, plus la quantité de courant qui peut passer à travers l'interconnexion est élevée, et donc plus la résistance électrique est faible. Or, la personne de métier appréciera que :
- dans le cas d'intégrations 3D classiques dans lesquelles les interconnexions comprennent des vias de section circulaire, le courant est limité par la faible surface des vias par rapport à celles des plots de collage. Pour des microstructures ayant un pas de collage, par exemple, de 5 µm, le diamètre de la section circulaire d'un via peut être de 0,5 µm, de sorte que la surface cumulée des quatre vias réalisés pour un plot de collage déterminé est égale à 4 × 3,14 × (0,25)², soit à 0,785 µm² ; alors que,
- dans le cas d'une interconnexion obtenue par la mise en oeuvre du procédé selon l'invention, c'est la surface totale des plots (en considérant un alignement optimal entre les plots respectifs des deux dispositifs microélectroniques 2D) qui réalise la surface de raccordement électrique pour le passage des électrons. La surface de contact de section carrée peut alors être égale à 2,5 × 2,5 µm, soit 6,25 µm² ce qui représente environ huit fois la surface cumulée de quatre vias conformes à une solution classique, donc un courant passant qui peut être huit fois plus élevé. Même en cas de défaut d'alignement, par exemple avec un désalignement de 50%, le gain de surface de contact représente un facteur quatre, ce qui signifie que la résistance de contact d'un élément de raccordement électrique est divisée par quatre, au moins, par rapport à l'art existant.

Par ailleurs, les plots de liaison étant directement connectés aux lignes de métal de la couche d'interconnexion horizontale qui est directement en-dessous de la couche supérieure de la structure d'interconnexion, on évite la formation des couches de passivation en nitrure de titane (TiN) qui sont classiquement utilisées dans les réalisations conformes à l'art antérieur, lesquelles ont l'inconvénient d'être plus résistives que le métal. Pour cette autre raison également, la résistance d'interconnexion est améliorée (elle est moins élevée), grâce à la mise en oeuvre de l'invention.

Selon encore un autre avantage, l'épaisseur de chacune des plaquettes peut être plus faible que dans les microstructures conformes à l'art antérieur, étant donné qu'il n'y a pas besoin d'une couche d'interconnexion de niveau HBV pour la réalisation de vias de raccordement des plots de liaison fonctionnels. Chaque plaquette est donc moins contrainte mécaniquement, ce qui procure de meilleures conditions de collage des deux plaquettes. De ce fait également, le risque de défauts de collage est réduit.

Globalement, et comme il sera explicité dans la description détaillée de modes de mise en oeuvre du procédé, le procédé de réalisation proposé permet l'économie de neuf étapes technologiques de fabrication, par rapport aux réalisations conformes à l'art existant. L'impact écologique et économique, ainsi que le gain de temps par rapport aux procédés connus, sont donc considérables. Notamment, le temps de cycle étant moins long, il y a moins de reprises en eau et donc un risque atténué de dégazage lors du recuit. En outre, il y a deux recuits en moins, ce qui apporte une réduction du budget thermique global.

### BRÈVE DESCRIPTION DES DESSINS

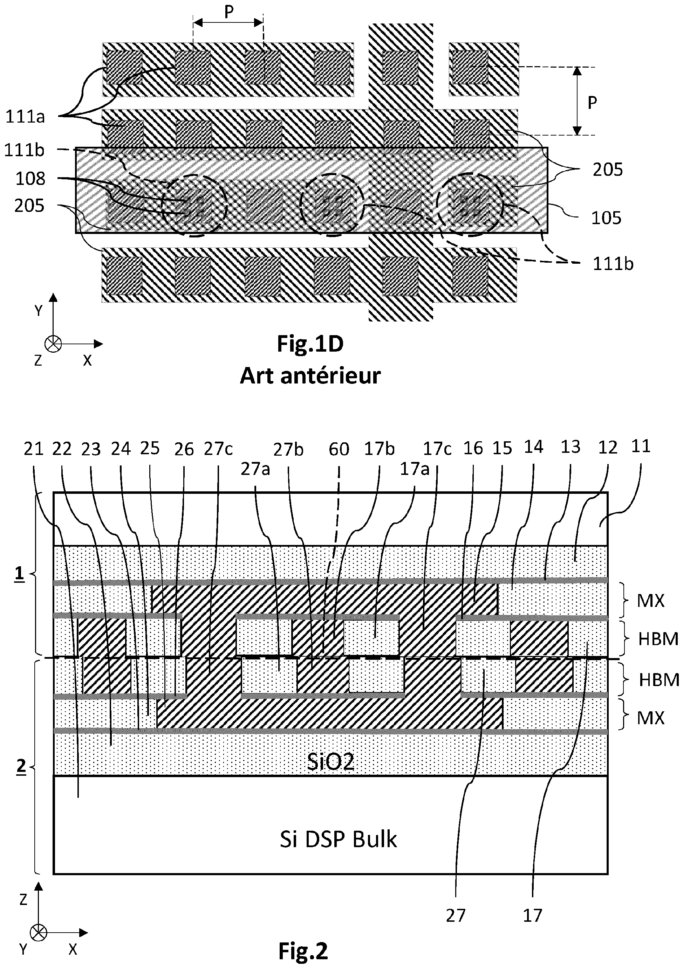

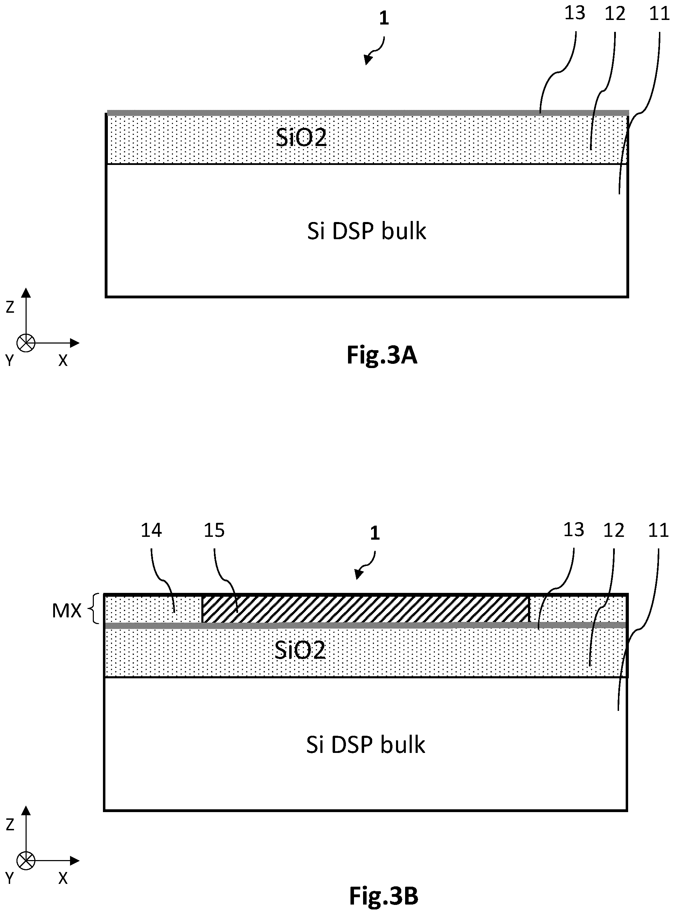

D'autres aspects, buts, avantages et caractéristiques de l'invention apparaîtront mieux à la lecture de la description détaillée suivante de formes de réalisation préférées de celle-ci. Cette description est donnée à titre d'exemple non limitatif. Elle est faite en référence aux dessins annexés, sur lesquels :
la figure 1A est une vue, en coupe verticale, d'un exemple de dispositif microélectronique 2D, adapté pour la réalisation d'une microstructure 3D par collage hybride avec un autre dispositif similaire, selon l'art existant ;
la figure 1B est une représentation schématique illustrant le principe de l'assemblage par collage hybride, de type W2W, de deux dispositifs microélectroniques 2D comme celui montré à la figure 1A, pour arriver à une microstructure 3D ;
la figure 1C est une vue, en coupe verticale, de la microstructure 3D obtenue par l'assemblage vertical de deux microstructures 2D telles que celle montrée à la figure 1A par collage hybride comme illustré par la figure 1B, conformément à l'art antérieur ;
la figure 1D est une vue de dessus d'un exemple de dispositif microélectronique 3D selon l'art antérieur, similaire à celui qui est représenté en coupe à la figure 1C ;
la figure 2 est une vue, en coupe verticale, d'un exemple de microstructure selon le second objet de l'invention ;
les figures de la figure 3A à la figure 3I sont des vues, en coupe verticale, d'un exemple de dispositif microélectronique 2D à diverses étapes de sa réalisation suivant un procédé conforme à des mises en oeuvre du premier aspect de l'invention, pour permettre la réalisation de la microstructure 3D de la figure 2 par l'assemblage vertical de deux tels dispositifs microélectroniques 2D identiques ou similaires ;

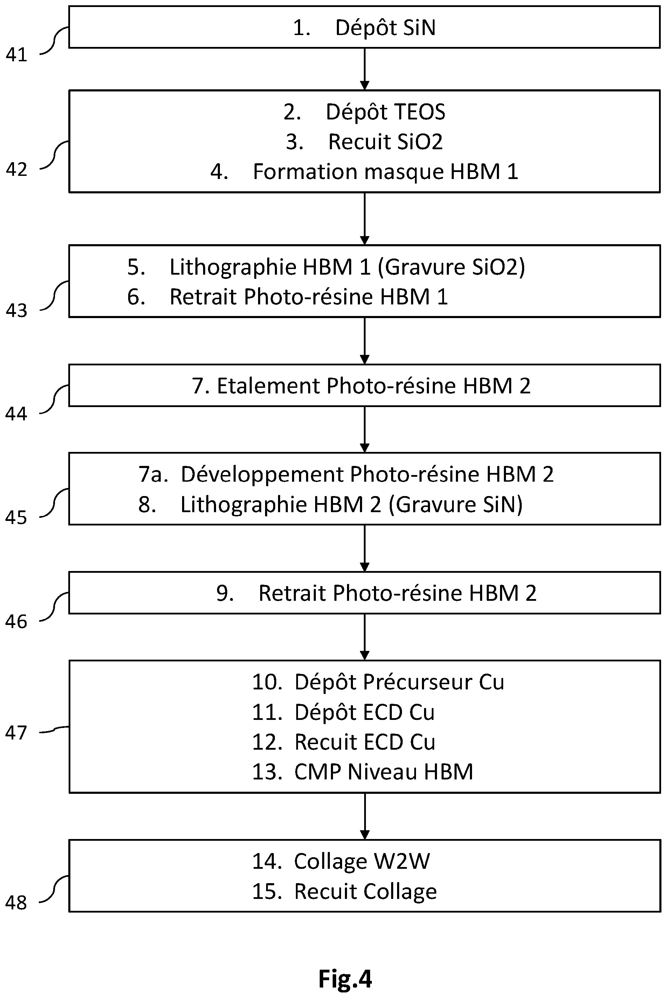

la figure 4 est un diagrammes d'étapes illustrant des groupes d'étapes du procédé selon des mises en oeuvre du procédé selon le premier aspect de l'invention, et des étapes d'un procédé conforme à l'art antérieur ; et,

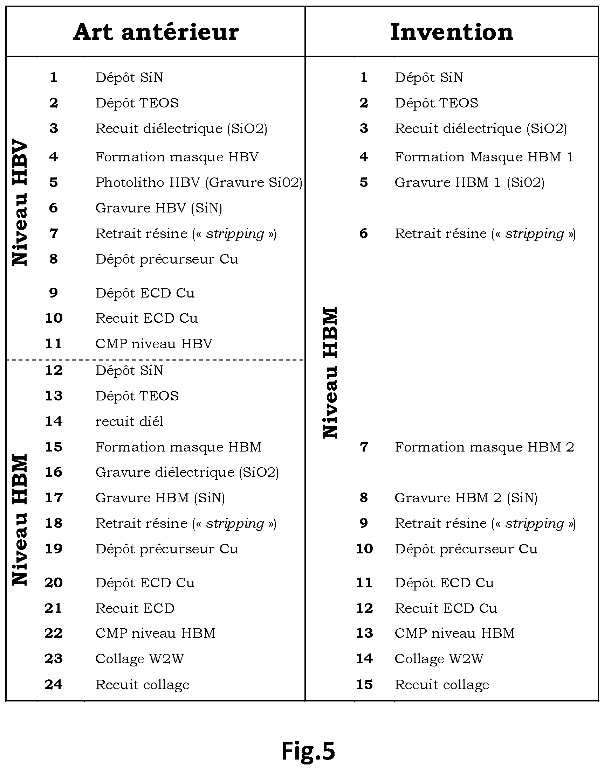

la figure 5 donne un tableau de comparaison, par mise en correspondance, des étapes d'un procédé conforme à l'art antérieur et des étapes du procédé selon des mises en oeuvre du premier aspect de l'invention, respectivement.

### DESCRIPTION DÉTAILLÉE DE MODES DE RÉALISATION

Sur les figures et dans la suite de la description, les mêmes références numériques désignent des éléments identiques ou similaires. De plus, les différents éléments ne sont pas représentés à l'échelle, de manière à privilégier la clarté des figures. Par ailleurs, les différents modes de réalisation et les variantes qui sont présentés ne sont pas exclusifs les-uns-des-autres et peuvent être combinés entre eux.

Dans ce qui suit, les termes "sensiblement", "environ", "de l'ordre de" signifient à 10% près, et de préférence à 5% près. Par ailleurs, les expressions "compris entre A et B", et les expressions équivalentes signifient que les bornes A et B sont incluses, sauf mention contraire explicite.

Par l'expression "formé à base de", utilisée en référence à un matériau et à un élément d'intérêt, on entend que le matériau est un composé formé d'une pluralité d'éléments dont au moins ledit élément d'intérêt.

Par l'expression "matériau comportant majoritairement" un élément d'intérêt, on entend un matériau dont au moins 50% en volume est formé par, ou comporte ledit élément d'intérêt.

Le terme "wafer" est un terme venant de l'anglais qui désigne une plaque très fine (aussi appelée "plaquette" du fait de sa faible épaisseur) de matériau semi-conducteur monocristallin, sur laquelle des dispositifs microélectroniques peuvent être réalisés. Les wafers sont ainsi utilisés pour fabriquer des dispositifs microélectroniques. Les wafers sont réalisés avec un matériau semi-conducteur dopé, comme le silicium (Si), l'arséniure de gallium (GaAs) ou le phosphure d'indium (InP). Les wafers présentent des dimensions généralement comprises entre 25,4 mm (technologie 1") et 300 mm (technologie 12"), pour une épaisseur de l'ordre de 0,7 mm. Les wafers sont employés dans l'industrie microélectronique en tant que support de fabrication de microstructures. Cette fabrication emploie des techniques de conception telles que par exemple et de manière non limitative : le dopage, la gravure, le dépôt d'autres matériaux et la photolithographie. Le matériau semi-conducteur dopé dont le wafer est constitué sert donc de substrat pour la création des microstructures formant les dispositifs microélectroniques actifs qui entrent dans la composition des circuits intégrés, des transistors, des produits semi-conducteurs de puissance, des MEMS ou NENS, etc.

Dans la fabrication d'un circuit intégré, la phase FE (« *Front End* ») désigne l'ensemble des étapes technologiques de fabrication du circuit avant sa mise en boîtier (« *packaging* »). La FE comprend la phase FEOL (de l'anglais « *Front End Of the Line* ») ainsi que la phase BEOL (de l'anglais « *back end of line* »). La FEOL désigne la première phase, dans laquelle sont exécutées l'ensemble des étapes de fabrication des composants actifs (transistors), par exemple en technologie CMOS, dans la zone active de la plaquette jusqu'au premier niveau de métallisation (mais celui-ci non-compris) de la structure d'interconnexion venant par-dessus. La BEOL désigne la deuxième phase de la fabrication du circuit intégré, qui commence à partir du premier niveau de métallisation de l'empilement des couches de métallisation formant la structure d'interconnexion par laquelle les composants actifs de la zone active de la plaquette sont interconnectés entre eux selon un plan de routage assurant le câblage des composants actifs sur la plaquette. Dans cette deuxième phase, en outre, des dispositifs microélectroniques individuels formant les composants passifs (condensateurs, inductances, résistances, etc.) peuvent être réalisés dans les différents niveaux de métallisation de la structure d'interconnexion. Les métaux couramment utilisés sont le cuivre (Cu) et l'aluminium (Al). La BEOL commence lorsque la première couche de métal est déposée sur la plaquette. Par extension, on désigne parfois par BEOL la structure d'interconnexion qui comprend les couches isolantes (diélectriques), les pistes en métal (connexions électriques horizontales), les vias (connexions électriques verticales entre les pistes, et les sites de liaison pour les connexions entre la puce et le boîtier (« *package* ») du circuit intégré.

Par l'expression "polissage mécanochimique" ou CMP (de l'anglais « *Chemical-Mechanical Polishing* »), déjà employée dans l'introduction, on désigne un processus de lissage de la surface d'une plaquette utilisant l'action combinée de forces mécaniques et chimiques, ayant comme effet l'enlèvement du (ou des) matériau(x) en surface de la plaque et l'effacement d'une éventuelle topographie de surface, avec pour résultat la planarisation de la surface de la plaquette exposée à ce processus.

Le "procédé Damascène" est une technique de formation d'éléments métalliques (aussi appelés « métallisations ») en cuivre, qui consiste à graver des tranchées et des trous de via dans une couche de matériau diélectrique, puis à remplir de cuivre les tranchées et les trous de via pour former des pistes conductrices et des vias, respectivement, et enfin à aplanir le cuivre à l'aide d'un polissage mécanochimique (CMP).

Le "recuit" d'un matériau est une opération correspondant à un cycle de chauffage, consistant en une étape de montée graduelle en température à des températures allant de 250°C à 450°C, environ, suivie d'un refroidissement contrôlé. Un recuit permet de modifier les caractéristiques physiques du matériau soumis à ce traitement thermique.

Le "dépôt électrolytique, ou électrochimique", ou encore ECD (de l'anglais « *ElectroChemical Déposition* »), est une technique de dépôt utilisée pour le remplissage rapide des tranchées ou des trous de via avec un métal comme le cuivre, par exemple. Son principe de mise en oeuvre est le suivant : la plaquette est configurée comme une électrode négative (cathode) et est immergée dans un électrolyte, i.e., une solution électrolytique contenant des sels métalliques. Le cuivre est déposé à partir d'une anode, *i.e*., une contre-électrode positive, en cuivre. Pour ce faire, les ions métalliques de l'anode sont réduits en appliquant une différence de potentiel entre cette anode et la cathode. Afin que la réaction se produise de façon homogène sur toutes les portions souhaitées de la surface de la plaquette, il faut que celles-ci soient conductrices. Dit autrement, il est donc nécessaire que la résistivité de la couche d'accroche sur les portions de la plaquette qui sont ciblées soit la plus faible possible.

Le terme "photo-résine" (« *photoresist* » en anglais) désigne un matériau, plus particulièrement une résine polymère, qui est sensible à la lumière et est utilisé pour former un motif sur le substrat, en utilisant un masque optique formé de zones opaques et de zones transparentes qui définissent le motif que l'on souhaite reproduire sur la plaquette à travers lequel la photo-résine est illuminée et a ses propriétés modifiées au niveau des zones transparentes du filtre optique. Ainsi par exemple, une photo-résine "positive" est un polymère sensible à la lumière qui, lorsqu'il est exposé à la lumière ultraviolette (UV), se transforme en un matériau soluble : les zones exposées à cette illumination peuvent alors être dissoutes à l'aide d'un solvant, laissant derrière elles une couche à motifs en creux qui peut être utilisée comme masque pour la formation d'une structure à travers le masque ainsi constitué, par exemple par une gravure d'un matériau sous-jacent qui est sélective au matériau du masque, par implantation ionique, ou par dépôt d'un nouveau matériau dans les zones exposées par le masque.

Enfin, on définit ici et pour la suite de la description un repère direct tridimensionnel orthogonal (X,Y,Z), où les axes X et Y forment un plan parallèle au plan principal de la plaquette "poignée" considérée, et où l'axe Z est orienté de manière sensiblement orthogonale au plan principal de ladite plaquette, cet axe Z étant orienté suivant la direction de la gravité. Dans la suite de la description, les termes "vertical" et "verticalement" s'entendent comme étant relatifs à une orientation sensiblement parallèle à l'axe Z, et les termes "horizontal" et "horizontalement" comme étant relatifs à une orientation sensiblement parallèle au plan (X,Y). Par ailleurs, les termes "dessus" et "dessous" ainsi que leurs dérivés (comme "au-dessus" et "au-dessous", ou "par-dessus" et "par-dessous"), ainsi également que les termes "inférieur" et "supérieur", utilisés pour qualifier un élément de la microstructure considérée, s'entendent comme étant relatifs à un positionnement croissant lorsqu'on s'éloigne du wafer vers le haut, i.e., suivant la direction verticale +Z.

Le terme "arrière" et le terme "avant", en revanche, sont utilisés en référence à la face d'une plaque par laquelle les différents traitements sont, ou ont été effectués pour réaliser la microstructure considérée. Ces traitements étant systématiquement réalisés par le haut lorsque la plaque est disposée à plat dans une enceinte utilisée pour effectuer le traitement, la face "avant" est généralement (et par défaut) la face supérieure de la plaquette. Toutefois, lorsqu'une plaque ou une puce découpée d'une plaque sont retournées verticalement, leur face avant devient la face inférieure et leur face arrière devient la face supérieure. Le qualificatif "arrière" attribué au substrat semi-conducteur d'une plaquette ou d'une puce individuelle est également utilisé en référence à cette convention, en ce sens qu'on désigne par-là la partie du substrat qui est la plus éloignée de la face de ladite plaquette ou de ladite puce au niveau de laquelle des traitements ont été réalisés dans le substrat, et que l'on qualifie toujours de face arrière quand bien même la plaquette ou la puce ont été retournées verticalement en sorte que cette face se trouve désormais au-dessus et tournée vers le haut.

Par "couche", on entend une étendue d'un matériau dont l'épaisseur suivant l'axe Z est inférieure, par exemple dix fois voire vingt fois, à ses dimensions longitudinales de largeur et de longueur dans le plan XY.

Par "plot", on entend un volume d'un matériau cristallin, par exemple à base d'un métal déterminé comme le cuivre ou l'aluminium, dont l'épaisseur suivant l'axe Z est sensiblement égale à ses dimensions longitudinales de largeur et de longueur dans le plan XY, et dont ses dimensions longitudinales sont inférieures ou égales à l'épaisseur suivant l'axe Z d'une couche dans laquelle ils sont réalisés. La forme du plot, dans un plan de coupe horizontal (parallèle au plan XY) peut être polygonale (par exemple un carré ou un rectangle), ou courbe (par exemple un cercle ou une ellipse).

Des modes de réalisation particuliers vont être décrits en se référant à l'exemple non limitatif de l'application à la réalisation d'une structure microélectronique 3D destinée à la fabrication d'un produit semiconducteur intégré, par exemple en technologie CMOS. Les modes de réalisation de cette microstructure 3D et les modes de mise en oeuvre du procédé décrits peuvent être adaptés aux particularités propres à chaque application concernée, sans se départir des enseignements de l'invention.

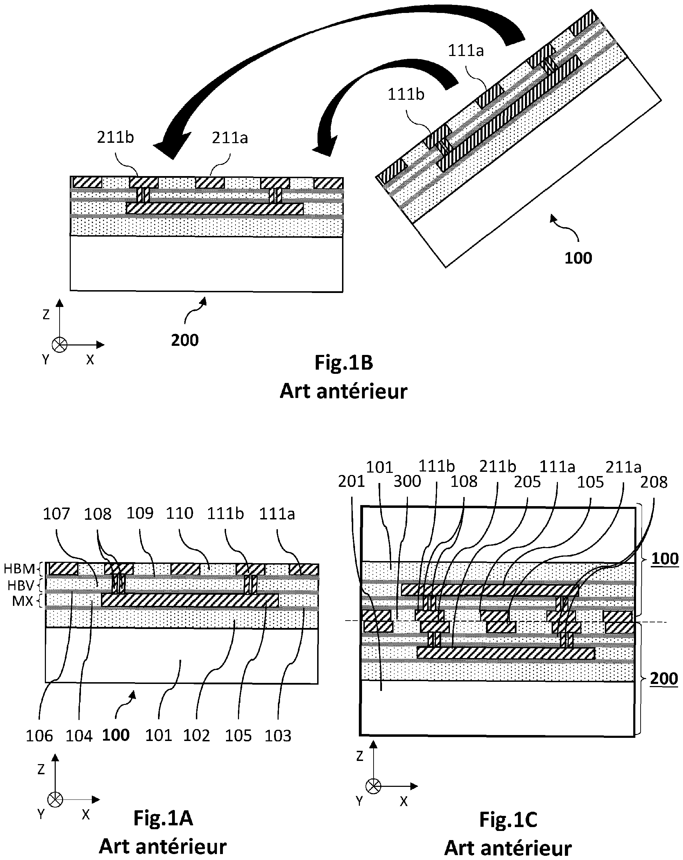

On va tout d'abord décrire, en référence aux schémas de la **figure 1A** à la **figure 1D****,** le principe de l'assemblage 3D par collage hybride selon l'art antérieur.

Un collage direct peut être utilisé dans l'intégration 3D. Deux matériaux diélectriques sont collés ensemble pour assembler deux plaquettes distinctes. Cependant, seule une liaison mécanique est réalisée et il n'y a pas de continuité électrique au niveau de l'interface de collage. La reprise des connexions électriques entre la plaquette supérieure et la plaquette inférieure peut être réalisée, après collage, en formant des vias traversants (TSV), qui sont des vias à rapport d'aspect élevé qui traversent les couches de SiO2 et/ou de Si, d'un côté à l'autre de l'interface de collage. Cette technique n'offre qu'une faible densité d'interconnexion entre les plaquettes. En outre, sa mise en oeuvre est relativement longue et complexe, car le procédé de mise en oeuvre de TSV comprend beaucoup d'étapes de gravure et d'étapes de dépôt.

Le collage hybride constitue une autre approche également bien connue, en soi, de la personne de métier. Selon cette approche, deux plaquettes sont traitées séparément, en suivant un processus d'intégration classique jusqu'à la réalisation du dernier des niveaux de métallisation standards de leur structure d'interconnexion respective, à savoir les *n* niveaux de métallisation empilés dits aussi niveaux M1, M2, ..., Mn. Après cette étape, un pénultième niveau de métallisation dit "niveau de via de collage hybride" (ou niveau HBV, de l'anglais « *Hybrid Bonding Vias* »), ainsi qu'un ultime (*i.e*., dernier) niveau de métallisation dit "niveau métallisation de collage hybride" (ou niveau HBM de l'anglais « *Hybrid Bonding Métal* »), sont ajoutés verticalement à la structure d'interconnexion de chacune des plaquettes, par poursuite du procédé Damascène après la réalisation des *n* niveaux de métallisation sous-jacents (ou niveaux M1, M2, ..., Mn). Le niveau HBM constitue le niveau de liaison de la plaquette pour le collage hybride avec l'autre plaquette, et contient à cet effet des plots de liaison. Le niveau HBV, qui est directement inférieur au niveau HBM, contient exclusivement des métallisations verticales pour le raccordement électrique de certains des plots de liaison du niveau HMB avec des niveaux de métallisation inférieurs M1, M2, ..., Mn. La différence avec le collage direct évoqué plus haut est la présence des plots de liaison en cuivre dans les niveaux de liaison respectifs des deux plaquettes, avec une densité élevée. Le matériau diélectrique dans ces niveaux est du SiO2 déposé par dépôt chimique en phase vapeur (PECVD). La très haute densité de plots de liaison présents dans cette couche de SiO2 offre de nombreux avantages, non seulement en termes de raccordement électrique entre les deux plaquettes une fois assemblées par collage hybride, mais également en termes de qualité du collage obtenu.

En référence à la **figure 1A****,** un premier dispositif microélectronique 100 selon l'art existant, par exemple un dispositif en technologie CMOS, comprend un substrat 101. Le substrat 101 est par exemple un substrat de silicium. Par-dessus le substrat 101, le dispositif 100 comprend une couche 102 de matériau électriquement isolant (diélectrique), comme du dioxyde de silicium (SiO2). La couche 102 est elle-même recouverte par une couche de passivation 103, par exemple une couche en nitrure de Silicium (SiN).

Le dispositif microélectronique 100 comprend une zone active (non représentée) dans le haut du substrat 101, directement en-dessous de la couche d'isolant 102. Cette zone active peut comprendre des composants actifs, comme des transistors, des dispositifs photoniques tels que des photodiodes, etc. De tels composants, le cas échéant, sont réalisés en utilisant par exemple les étapes technologiques de fabrication qui sont les étapes classiques de la microélectronique en technologie CMOS, afin de réaliser un circuit intégré pour une application déterminée. Cette phase de la fabrication du circuit (ou phase FEOL) ne sera pas abordée dans la présente description, car l'invention est mise en oeuvre durant la phase BEOL subséquente, à savoir la phase de réalisation de la structure d'interconnexion. Cette structure d'interconnexion va maintenant être décrite, toujours en référence à la figure 1A.

Le dispositif microélectronique 100 comprend en effet une structure d'interconnexion formée d'un empilement de *n* couches correspondant chacune à un niveau de métallisation respectif, où *n* est un nombre entier strictement supérieur à l'unité. Ces *n* couches d'interconnexion sont réalisées essentiellement en un matériau électriquement isolant (diélectrique), comme du dioxyde de silicium (SiO2). Elles contiennent des éléments métalliques, à savoir des pistes conductrices ou des vias. Ces éléments métalliques (aussi appelés "métallisations" par raccourci) sont réalisés par dépôt de métal dans des tranchées ou des trous de via, respectivement, préalablement formées par tout procédé ad-hoc, dans le matériau diélectrique de la couche d'interconnexion correspondante. Les tranchées et les trous de vias sont généralement formés par gravure photo-lithographique, puis remplies de métal. Le métal en question est généralement du cuivre (Cu), mais il pourrait éventuellement s'agir d'un autre métal, comme de l'aluminium (Al) par exemple. Les couches de la structure d'interconnexion correspondent à des niveaux de métallisation respectifs qui sont communément désignées par les acronymes M1, M2, ..., Mn dans la littérature concernée. Il y a une alternance de niveaux de métallisation horizontale comprenant des pistes conductrices réalisée par dépôt de métal dans des tranchées formées dans le matériau diélectrique de la couche correspondante, et de niveaux de métallisation verticale comprenant des vias réalisés par dépôt de métal dans des trous de vias formés dans le matériau diélectrique de la couche correspondante. Les vias d'un niveau de métallisation verticale sont agencés pour coupler des pistes conductrices d'un niveau de métallisation au-dessus (le cas échéant) avec des pistes conductrices d'un niveau de métallisation au-dessous et/ou avec des éléments actifs de la zone active du substrat 101

Dans l'exemple de la figure 1A, *n* est égal à trois (*n*=3) : la structure d'interconnexion comprend trois couches 104, 107 et 110 empilées verticalement, dans cet ordre, au-dessus de la couche d'isolant 102 dont est revêtu le substrat 101. Elles sont formées successivement au-dessus du substrat 101, l'une après l'autre, en commençant par la couche la plus basse et en terminant par la couche la plus haute. Dans cet exemple, la couche 104 est la couche inférieure de la structure d'interconnexion, ou couche la plus basse, c'est-à-dire aussi celle qui est la plus proche du substrat 101. Elle correspond au premier niveau de métallisation, dénoté MX à la figure et dans la suite, qui est formé directement au-dessus du substrat 101. A l'opposé suivant la direction verticale Z, la couche 110 est la couche supérieure de la structure d'interconnexion, ou couche la plus haute, c'est-à-dire aussi celle qui est la plus éloignée du substrat 101. Elle correspond au dernier niveau de métallisation qui, dans le contexte de la présente description, est désigné par l'acronyme HBM (mis pour « *Hybrid Bonding Métal* », en anglais). Enfin, la couche 107 est l'avant-dernière couche de la structure d'interconnexion, formée directement en-dessous de la couche supérieure 110 avec laquelle elle coopère directement d'un point de vue fonctionnel, et est désignée par l'acronyme HBV (mis pour « *Hybrid Bonding Vias* », en anglais) dans le contexte de la présente description. La fonction de ces trois couches d'interconnexion, *i.e*., niveaux de métallisation MX, HBM et HBV est détaillée dans ce qui suit.

Dans l'exemple montré à la figure 1A, la première couche d'interconnexion 104 de la structure d'interconnexion, i.e., celle qui est la plus proche du substrat 101, correspond à un niveau de métallisation horizontale MX. Dans l'exemple montré, ce niveau de métallisation MX comprend une piste conductrice 105 réalisée dans une tranchée, i.e., un évidement traversant formé dans le matériau diélectrique, qui s'étend ici suivant la direction longitudinale X. Le cas échéant, cette piste conductrice 105 peut être raccordée électriquement à un ou plusieurs composants actifs réalisés dans la zone active du substrat 101 du dispositif 100. Plus généralement, les métallisations horizontales formées dans le niveau de métallisation MX de la première couche 104 ont pour fonction de raccorder entre eux des éléments des composants actifs réalisés dans la zone active du substrat 101. A cet effet, elles leur sont couplées par des vias (non représentés). Ces vias traversent la couche d'isolant 102 qui est directement en-dessous de la couche 104 ainsi que la couche de passivation 103 qui sépare les deux couches de matériau diélectriques 102 et 104.

La dernière couche 110 de la structure d'interconnexion représentée à la figure 1A, qui correspond au niveau de métallisation HBM, comprend des plots de liaison métalliques ayant pour fonction d'assurer la liaison par collage hybride de la plaquette 100 avec une autre plaquette 200. Plus spécifiquement, elle comprend des plots de liaison d'un premier type 111a, ainsi que des plots de liaison d'un second type 111b. Tous ces plots servent à la liaison du dispositif microélectronique correspondant à la plaquette 100 par collage hybride avec un autre dispositif microélectronique correspondant à la plaquette 200. Structurellement, ces deux types de plots sont identiques, et ils sont réalisés dans le même métal, à savoir le cuivre dans l'exemple, et de la même façon par mise en oeuvre du procédé Damascène. La différence entre ces deux types de plots est uniquement fonctionnelle.

En effet, d'un côté, les plots de liaison 111a du premier type servent uniquement, *i.e.*, exclusivement de support de collage pour le collage hybride de la plaquette 100 sur l'autre plaquette 200, comme montré à la **figure 1B****,** en coopération avec des plots de liaison correspondants 211a de ladite autre plaquette 200. De ce fait, les plots de liaison 111a du premier type seront aussi appelés "plots de collage seulement" dans la suite, ou encore "plots non-fonctionnels" car ils ne jouent aucun rôle dans le fonctionnement opérationnel du circuit intégré.

D'un autre côté, les plots de liaison 111b du second type servent non seulement au collage entre elles des deux plaques 100 et 200, comme les plots 111a de collage seulement, mais ils servent en outre au raccordement électrique entre lesdites plaquettes, en coopération avec des plots correspondants 211b de l'autre plaquette 200. Dans ce qui suit, les plots de liaison 111b du second type sont appelés "plots de collage et de raccordement électrique", ou "plots fonctionnels" car ils jouent un rôle dans le fonctionnement opérationnel du circuit intégré en assurant le passage de signaux électriques d'une plaquette à l'autre.

Enfin, l'avant-dernière couche 107 de la structure d'interconnexion de la figure 1A, c'est-à-dire la couche d'interconnexion directement au-dessous de la couche d'interconnexion supérieure 110, qui correspond au niveau de métallisation HBV, comprend des vias 108. Ces vias 108 sont des éléments de métallisation verticale adaptés pour réaliser un couplage électrique entre un plot de liaison fonctionnel du niveau de métallisation HBM dans la couche d'interconnexion supérieure 110, d'une part, et un élément de métallisation du niveau de métallisation MX dans la couche d'interconnexion inférieure 104, d'autre part.

Dans l'exemple montré à la figure 1C, de tels vias 108 sont réalisés en continuité électrique avec les plots 111b de collage et de raccordement électrique de la plaquette 100 du niveau de métallisation HBM formé directement au-dessus du niveau de métallisation HBV, et également en continuité électrique avec la piste conductrice 105 dans le niveau de métallisation MX en-dessous du niveau de métallisation HBV. Les vias 108 ont pour fonction de raccorder électriquement les éléments de métallisation auxquels ils sont respectivement couplés, c'est-à-dire avec lesquels ils sont en continuité électrique. Le cas échéant, de tels via 108 peuvent assurer la continuité électrique de plots de liaison du second type 111b directement avec des éléments de métallisation répartis dans des couches de métallisation encore plus basses que la couche 104 de la figure 1A dans l'empilement des n couches d'interconnexion, et même directement avec des éléments actifs réalisés dans la zone active du substrat 101. Ces vias 108 peuvent traverser une (ou plusieurs) couche(s) intermédiaire(s) de matériau diélectrique à base dioxyde de silicium (SiO2) avant d'atteindre une métallisation horizontale dans une couche d'interconnexion correspondant à un niveau de métallisation horizontale située plus bas dans l'empilement, ou bien un élément actif de la zone active du substrat 101.

La personne du métier appréciera en effet que plusieurs niveaux de métallisation horizontale comme le niveau de métallisation MX peuvent être formés dans des couches d'interconnexion respectives qui sont réalisées en empilement avant de former l'avant-dernière couche 107 et la dernière couche 110 de la structure d'interconnexion, lesquelles correspondent aux niveaux HBV et HBM, respectivement. Le cas échéant, les métallisations horizontales formées dans ces couches d'interconnexion respectives peuvent être reliées entre elles par des métallisations verticales, i.e., par des vias qui sont réalisés dans des couches d'interconnexion dédiées correspondant à des niveaux de métallisation verticale respectifs, intercalées entre les couches d'interconnexion horizontale correspondantes.

La figure 1B illustre symboliquement le collage hybride de la plaquette 100 de la **figure 1A** sur l'autre plaquette 200. Il peut s'agir d'un collage hybride au niveau plaque, c'est-à-dire un collage de type W2W, mais il peut aussi s'agir d'un collage hybride de type D2W ou même d'un collage hybride de type D2D. La **figure 1C** illustre la microstructure 3D obtenue par cet assemblable vertical. Comme symboliquement représenté par une flèche, la plaquette supérieure 100 est retournée verticalement, et est calée dans le plan horizontal XY (c'est-à-dire qu'elle est alignée à la fois suivant la direction longitudinale X et suivant la direction transversale Y) par rapport à la plaquette inférieure 200. Ce résultat est obtenu par mise en référence de ses plots de liaison 111a du premier type ainsi que ses plots de liaison du second type 111b, avec les plots de liaison correspondants de la plaquette inférieure 200. Cette opération est réalisée selon des méthodes, et par la mise en oeuvre d'équipements qui sont connus de la personne du métier, et dont la description détaillée sortirait du cadre de la présente description. Le collage de la plaquette supérieure 100 sur la plaquette inférieure 200, comme montré à la figure 1B, est obtenu par l'effet des forces de Van der Waals, des liaisons covalentes et des liaisons hydrogènes mises en oeuvre lors de la mise en contact, en raison de l'état de surface particulièrement lisse et plan des faces supérieures respectives des plaquettes 100 et 200.

La **figure 1D** est une vue de-dessus d'une microstructure 3D obtenue par une méthode d'intégration verticale selon l'art existant qui a été présenté ci-dessus. Cette microstructure peut correspondre à la microstructure représentée à la figure 1C, ou à toute microstructure structurellement comparable. En référence à la figure 1D, on distingue :
- des lignes métalliques 205 qui sont réalisées dans le niveau de métallisation MX de la structure d'interconnexion de la plaquette inférieure 200 ;
- une ligne métallique 105, ici représentée en légère transparence afin de laisser apparaître ce qu'il y a en-dessous, et qui est réalisée dans le niveau de métallisation MX de la structure d'interconnexion de la plaquette supérieure 100 ;
- les plots de liaison 111a et 111b de la plaquette supérieure 100, qui comprennent des plots de collage seulement ou plots du premier type 111a, ainsi que des plots de collage et de raccordement électrique ou plots du second type 111b (lesquels sont entourés par des cercles en traits pointillés à la figure, afin de mieux les distinguer). Ces plots de liaison 111a et 111b coïncident spatialement, dans le plan horizontal XY, avec les plots de liaison correspondants de la plaquette inférieure 200 dans la vue de dessus de la figure 1D, en faisant l'hypothèse d'un alignement horizontal parfait entre les deux plaquettes 100 et 200. Dit autrement, les plots de liaison 111a et 111b de la plaque supérieure 100 sont parfaitement alignés suivant la direction X comme suivant la direction Y avec les plots de liaison correspondants 211a et 221b (voir figure 1C) de la plaquette inférieure 200. Par conséquent, ils masquent ces derniers dans une direction d'observation suivant la direction verticale Z, du dessus vers le bas. Les plots de liaison 211a et 221b (voir figure 1C) de la plaquette inférieure 200 ne sont donc pas visibles à la figure 1D ;
- les vias 108 qui sont réalisés dans le niveau de métallisation HBV de la structure d'interconnexion de la plaquette supérieure 100, et qui sont représentés par de petits carrés dans les plots de collage et de raccordement 1 11b. Ici aussi, et en faisant toujours l'hypothèse d'un alignement horizontal parfait entre les deux plaques 100 et 200, les vias 108 de la plaque supérieure 100 masquent les vias correspondants 208 de la plaque inférieure 200. Dans l'exemple représenté, il y a quatre vias de section carrée pour raccorder une paire de plots de raccordement 108 et 208, afin de permettre le passage d'un courant quatre fois plus important qu'avec un unique via de section identique. Le nombre et la forme de la section des vias peuvent varier d'une application à l'autre. Par exemple, des vias de section rectangulaire, circulaire ou élliptique peuvent être préférés. Un nombre de vias inférieur à quatre, par exemple un seul via de section relativement plus grande, peut aussi être prévu au lieu des quatre vias de section relativement plus petite qui sont représentés dans l'exemple de la figure 1D.

A la figure 1D, le pas de collage défini comme l'espacement c'est-à-dire la distance centre-à-centre entre deux plots de liaison adjacents (qu'ils soient du premier type 111a ou du second type 111b), à la fois suivant la direction X et suivant la direction Y, est dénoté par la lettre « P ». Comme on le voit sur la figure qui représente une réalisation conforme à l'art antérieur, mais comme c'est également le cas pour une réalisation mettant en oeuvre l'invention, les plots de liaison 111a et 111a sont présents avec une densité relativement importante, qui se traduit par un pas de collage P qui est inférieur à un seuil déterminé. Ce seuil est égal ou inférieur à 10 micromètres (µm), par exemple de l'ordre de 5 µm environ. En outre, leur répartition à la surface de la plaquette 100 est sensiblement uniforme, pour les raisons déjà mentionnées *supra.* Ces contraintes sont généralement spécifiées dans le DRM applicable, auquel le designer du circuit électronique concerné peut se référer.

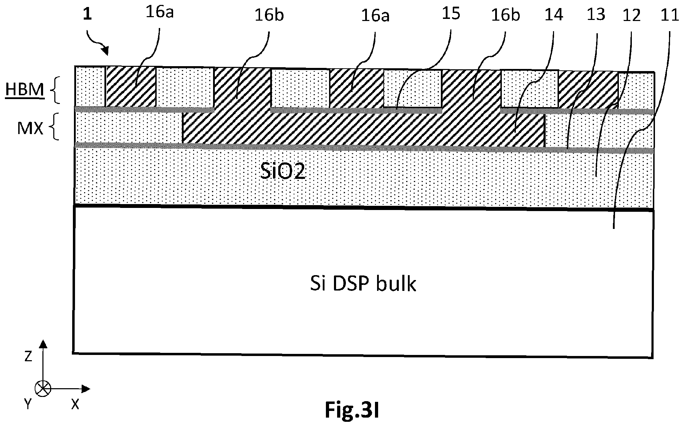

Un exemple de mise en oeuvre du procédé de réalisation d'une microstructure 3D par intégration verticale de deux plaquettes distinctes 1 et 2 conformément à l'invention, va maintenant être exposé en référence au diagramme d'étapes de la **figure 4****.** La mise en oeuvre du procédé permet de réaliser l'exemple de microstructure 3D montré à la **figure 2****,** comprenant la plaquette supérieure 1 retournée et collée sur la plaquette inférieure 2. Dans cet exposé, il sera également fait références aux vues en coupe de la **figure 3A** à la **figure 3I****.** Ces dernières figures montrent l'une des plaquettes en cours de réalisation, en l'occurrence la plaquette supérieure 1, à l'issue de la mise en oeuvre d'étapes ou de groupes d'étapes déterminées du procédé pour ladite plaquette 1 individuellement, avant le collage hybride des deux plaquettes 1 et 2. On notera que, dans l'exemple très simplifié considéré ici, la réalisation de la plaquette inférieure 2 de la microstructure 3D est identique ou comparable à celle de la plaquette supérieure 1, laquelle sera donc seule décrite ici afin de ne pas alourdir inutilement la présente description. En outre, et toujours par souci de simplification, les structures de métallisation respectives de la plaquette supérieure 1 et la plaquette inférieure 2 représentées sont structurellement identiques l'une à l'autre. Ceci n'est toutefois qu'un exemple non limitatif.

La **figure 2** montre la microstructure 3D résultant du collage hybride de la plaquette 1 dotée d'une structure d'interconnexion originale obtenue par la mise en oeuvre du procédé selon le second aspect de l'invention, sur une autre plaquette 2 (ou plaquette inférieure) ayant une structure d'interconnexion obtenue de manière similaire.

La microstructure 3D de la figure 2 contient un premier dispositif microélectronique réalisé sur une plaquette supérieure 1, ainsi qu'un second dispositif microélectronique réalisé sur une plaquette inférieure 2 sur laquelle la plaquette supérieure 1 est collée par collage hybride après retournement vertical. La plaquette inférieure 2 et la plaquette supérieure 1 comprennent chacune un substrat sensiblement plan, respectivement 11 et 21, ainsi qu'une structure d'interconnexion formée au-dessus dudit substrat.

La structure d'interconnexion respective de chacune des plaquettes supérieure 1 et inférieure 2 est un empilement vertical d'au moins deux niveaux d'interconnexion superposés et comprenant chacun une couche hybride essentiellement composée d'un matériau diélectrique, à savoir, respectivement :
- un niveau d'interconnexion supérieur (HBM), avec des plots de liaison métalliques 17b et 17c, formés dans le matériau diélectrique et adaptés pour coopérer avec des plots de liaison métalliques correspondants 27b et 27c, respectivement de l'autre plaquette 2 pour le collage hybride de la plaquette supérieure 1 sur la plaquette inférieure 2 ; et,
- un niveau d'interconnexion horizontale (MX) qui est directement en-dessous du niveau d'interconnexion supérieur HBM, avec des éléments de métallisation horizontales 15 et 25.

Par l'adverbe « essentiellement » utilisé ci-dessus en référence à la composition de la couche hybride de chacun des niveaux HBM et MX, il faut comprendre que l'un et/ou l'autre de ces niveaux peuvent comprendre en outre, et par exemple, une couche de passivation prévue pour passiver le matériau diélectrique qui entre dans la composition dudit niveau. En outre, par l'expression « directement en-dessous » utilisée ci-dessus en relation avec le niveau d'interconnexion horizontale MX, il faut comprendre qu'il n'y a pas d'autre niveau d'interconnexion entre le niveau HBM et ledit niveau MX, et donc pas de niveau d'interconnexion verticale. Dit autrement, la personne de métier appréciera que cela signifie que le premier niveau de métallisation (ici, le niveau MX) qui vient en-dessous du niveau de collage hybride HBM dans l'empilement de niveaux d'interconnexion, est un niveau de métallisation horizontale et non un niveau de métallisation verticale. Mais cela n'empêche pas que le niveau d'interconnexion horizontale MX puisse comprendre, sur le dessus dudit niveau et donc en-dessous du niveau de métallisation HBM, une couche de passivation, par exemple une couche en Nitrure de Silicium (SiN) comme il sera exposé plus loin. En d'autres termes, cela n'implique pas que toutes les portions diélectriques et/ou toutes les portions métalliques du niveau HBM sont directement en contact avec des portions diélectriques et/ou des portions métalliques du niveau MX.

Les plots de liaison métalliques 17b, 17c et 27b,27c de chacune des plaquettes supérieure 1 et inférieure 2, respectivement sont répartis de manière sensiblement homogène à la surface supérieure du niveau d'interconnexion supérieur HBM de la structure d'interconnexion de ladite plaquette. Également, ils sont réalisés avec un pas de collage, défini comme l'espacement maximum entre des plots de liaison adjacents horizontalement dans le plan de ladite surface supérieure, qui est inférieur à un seuil associé déterminé. Ce seuil peut être inférieur ou égal à 10 µm, ce qui procure une forte densité d'interconnexion entre les deux plaques 1 et 2 par l'intermédiaire des plots de liaison. De préférence, il peut être de l'ordre de 5 µm, par exemple.

Les plots de liaison métalliques respectifs 17b, 17c et 27b,27c de chacune des plaquettes supérieure 1 et inférieure 2 comprennent des plots de liaison respectivement 17b et 27b d'un premier type, qui sont isolés électriquement de tout élément de métallisation horizontale comme les métallisations 15 et 25, respectivement, du niveau d'interconnexion horizontale MX de la structure d'interconnexion de ladite plaquette. Par ailleurs, les plots de liaison métalliques respectifs 17b, 17c et 27b,27c de chacune des plaquettes supérieure 1 et inférieure 2 comprennent en outre des plots de liaison respectivement 17c et 27c d'un second type, qui sont couplés électriquement chacun à au moins un élément de métallisation horizontale sous-jacent, formé dans le niveau de métallisation horizontale MX de la structure d'interconnexion de ladite plaquette.

Dit autrement, la structure d'interconnexion de chacune des plaquettes supérieure 1 et inférieure 2 de la microstructure de la figure 2 ne comprend pas de niveau de métallisation verticale directement en dessous du niveau HBM, contrairement à la microstructure 3D de la figure 1D conforme à l'art existant qui a déjà été décrite dans ce qui précède, et qui possédait un tel niveau de métallisation verticale à savoir le niveau HBV. Au lieu de cela, les plots de liaison du second type 17c ou 27c, respectivement, du niveau de métallisation HBM de la structure d'interconnexion de chacune des plaquettes 1 et 2, assurent le raccordement électrique de ladite plaquette avec l'autre plaquette. On élimine ainsi un niveau de métallisation dans chacune des plaquettes 1 et 2, donc deux niveaux de métallisation pour la microstructure 3D formée de ces deux plaquettes empilées. Pour chacun de ces niveaux, on évite donc une couche de matériau isolant (par ex. en SiO2) et sa couche de passivation (par ex. en SiN) associée. Cela réduit le niveau de stress de la microstructure 3D, car celui-ci dépend du nombre de couches des structures d'interconnexion des plaquettes. Bien entendu, on réduit aussi les coûts et budgets thermique, eau, etc. pour la réalisation des dispositifs semiconducteur 2D individuels, qui sont réalisés chacun sur l'une des plaquettes 1 et 2.

Dans des modes de réalisation, le niveau d'interconnexion horizontale MX de la structure d'interconnexion de chacune des plaquettes inférieure 1 et supérieure 2 comprend un film de passivation 16 ou 26, respectivement, réalisé en matériau électriquement isolant, et qui recouvre la couche en matériau diélectrique dudit niveau de métallisation horizontale MX. Les plots de liaison du premier type 17b et 27b de chacune des plaquettes supérieure 1 et inférieure 2, respectivement, sont alors isolés électriquement de tout élément de métallisation horizontale du niveau d'interconnexion horizontale MX situé en dessous dans la structure d'interconnexion de ladite plaquette, au moins par le matériau isolant de ce film de passivation 16 ou 26 recouvrant la couche de matériau diélectrique dudit niveau de métallisation horizontale MX.

Dans des modes de réalisation, la couche 17 ou 27 de matériau diélectrique du niveau d'interconnexion supérieur HBM de la structure d'interconnexion de chacune des plaquettes 1 et 2, respectivement, est une couche hybride de matériau diélectrique à motifs, lesdits motifs définissant :
- des zones 17a ou 27a pleines dudit matériau diélectrique, c'est-à-dire des zones de la couche 17 ou 27 qui n'ont pas été gravées ;
- des premiers trous traversants verticalement 17b ou 27b, emplis de matériau métallique et au niveau desquels le matériau isolant de la couche de passivation du niveau d'interconnexion horizontale MX est présent. Ces premiers trous traversants, une fois remplis de métal, forment les plots de liaison du premier type (également désignés par les références 17b et 27b dans ce qui suit) du niveau d'interconnexion supérieur HBM de la plaquette ; et,
- des seconds trous traversants verticalement 17c ou 27c, emplis de matériau métallique, et au niveau desquels la couche de passivation 16 ou 26 du niveau d'interconnexion horizontale MX présente une ouverture parce que le Nitrure de Silicium (SiN) de ladite couche de passivation 16 ou 26, respectivement, y a été enlevé par gravure. Ces seconds trous traversants, une fois remplis de métal, forment les plots de liaison du second type (également désignés par les références 17c et 27c dans ce qui suit) du niveau d'interconnexion supérieur HBM de la plaquette. Ils sont chacun en continuité électrique avec l'un des éléments de métallisation horizontale 15 ou 25 du niveau d'interconnexion horizontale MX de la plaquette 1 ou 2, respectivement, à travers l'ouverture dans la couche de passivation 16 ou 26, respectivement, dudit niveau d'interconnexion horizontale MX.

Ainsi que la personne du métier l'aura compris, c'est donc la couche de passivation 16 du niveau de métallisation MX qui, en fonction des ouvertures pratiquées ou non dans ladite couche, et plus spécifiquement au droit des trous 17c et 17b réalisés dans la couche 17 correspondant au niveau de métallisation supérieur HBM pour recevoir le métal des plots de liaison fonctionnels 17c ou des plots de liaison non fonctionnels 17b, respectivement, qui permet de différencier la fonction desdits plots de liaison fonctionnels 17c de celle des plots de liaison non-fonctionnels 17b. En effet, le Nitrure de Silicium (SiN) de la couche de passivation, lorsqu'il est encore présent, empêche la continuité électrique entre le plot de liaison concerné du niveau de métallisation HBM et tout élément de métallisation dans le niveau de métallisation horizontale MX directement en-dessous dudit niveau HBM.

Dans des modes de réalisation, le matériau diélectrique des couches hybrides d'interconnexion de la structure d'interconnexion de chacune des plaquettes supérieure 1 et inférieure 2 est du Dioxyde de Silicium (SiO2). Le matériau constitutif des plots de liaison métalliques 17b, 17c et 27b,27c du niveau d'interconnexion supérieur HBM et/ou le matériau constitutif des métallisations horizontales 15 et 25 du niveau d'interconnexion horizontale MX de la structure d'interconnexion des plaquettes 1 et 2, respectivement, peut être du cuivre (Cu) ou un alliage à base de cuivre. Enfin, le matériau électriquement isolant du film de passivation 16 ou 26 du niveau d'interconnexion horizontale (MX) de la structure d'interconnexion de chacune des plaquettes 1 et 2 peut être un nitrure, comme le nitrure de silicium (SiN) ou un autre diélectrique, par exemple un dérivé carboné d'un nitrure comme du carbonitrure de silicium (SiCN).

Ainsi, après le retournement vertical et le collage de la plaquette 1 sur la plaquette 2 permettant de former la microstructure montrée à la figure 2, l'interface de collage 60 est une interface hybride. En effet, elle comprend :
- une interface SiO2 / SiO2 au niveau des zones 17a et 27a en regard ; et,
- une interface Cu / Cu au niveau des plots de collage non-fonctionnels 17b et 27b en regard, ainsi qu'au niveau des plots de collage fonctionnels 17c et 27c en regard.

Le substrat 11 de la plaquette supérieure 1 et/ou le substrat 21 de la plaquette inférieure 2 peuvent comprendre chacun une zone active avec des éléments actifs, dans la partie supérieure dudit substrat. Dans ce cas :
- les plots de liaison non-fonctionnels 17b et 27b de la structure d'interconnexion de chacune des plaquettes 1 et 2 sont électriquement isolés des éléments actifs de la zone active du substrat 11 ou 21, respectivement, de ladite plaquette ; alors que,
- certains au moins des plots de liaison fonctionnels 17c et 27c de la structure d'interconnexion de la plaquette supérieure 1 et/ou de la plaquette inférieure 2 sont couplés électriquement à au moins l'un des éléments actifs de la zone active du substrat 11 ou 21, respectivement, de ladite plaquette.

Des modes de mise en oeuvre d'un procédé de réalisation de la microstructure 3D de la figure 2 qui a été présentée dans ce qui précède, vont maintenant être décrits. Ce procédé comprend quinze étapes technologiques essentielles, auxquelles il sera fait référence dans ce qui suit par les numéros 1 à 15. Le regroupement de certaines de ces étapes dans certains des blocs d'étapes du diagramme d'étapes de la figure 4 vise uniquement à alléger la description qui suit. Notamment les figures représentant la microstructure en cours de réalisation sont limitées à la représentation de la plaquette à l'issue de chacun des groupes d'étapes considérés, lorsqu'une représentation séparément à l'issue de chaque étape du groupe n'apporterait rien de plus à la clarté de l'exposé.

Comme il a été indiqué en introduction, le procédé est essentiellement mis en oeuvre pendant la phase BEOL de la fabrication de chaque plaquette individuellement, lesquelles sont ensuite assemblées verticalement l'une à l'autre par collage hybride. Plus précisément, le procédé propose une alternative à la réalisation de l'avant-dernière couche et de la dernière couche de la structure d'interconnexion qui correspondent au niveau de métallisation HBV (interconnexion verticale) et au niveau de métallisation HBM, respectivement, d'une plaquette selon l'art existant, et qui ont été présentés plus haut en référence à la figure 1A. Ces deux couches sont remplacées, conformément à l'invention, par une unique couche de liaison assurant à elle-seule les fonctions respectives des niveaux de métallisation HBV et HBM respectifs de deux plaquettes assemblées verticalement selon l'art existant. On rappelle que, dans les structure d'interconnexion selon l'art existant, la dernière couche (niveau de métallisation HBM) est celle dans laquelle sont réalisés les plots de liaison (plots non-fonctionnels et plots fonctionnels) pour le collage hybride, alors que l'avant-dernière couche (niveau de métallisation verticale HBV) est celle dans laquelle sont réalisés les vias qui interconnectent verticalement les plots de liaison fonctionnels (et seulement ceux-ci, *i.e*., pas les plots de liaison non-fonctionnels) avec des métallisations horizontales réalisées dans un ou dans plusieurs niveaux de métallisation plus bas dans la structure d'interconnexion, et/ou avec des éléments actifs réalisés dans la zone active du substrat sous-jacent.

A la fin de la phase FEOL de la fabrication de la plaquette 1, à laquelle la phase BEOL succède, ladite plaquette est telle que représentée à la **figure 3A****.** La plaquette 1 comprend un substrat 11 qui est revêtu d'une couche de matériau isolant 12, elle-même recouverte d'une couche de passivation 13.

Le substrat 11 est par exemple un substrat de silicium massif (« *Si bulk* »). Dans sa partie supérieure, située sous la couche d'isolant 12, le substrat 11 comprend des composants actifs, non représentés, comme des transistors ou des photodiodes. Ces éléments ont été réalisés, par exemple en technologie CMOS, pendant la phase FEOL de la fabrication de la plaquette 1. La faible résistivité d'un substrat de silicium massif est avantageuse pour des raisons de verrouillage (« *latch-up* », en anglais) de tels transistors MOS. Dans un exemple, le substrat 11 est un substrat de type DSP (de l'anglais
« *Double Side Polished* »), qui a l'avantage d'être directement utilisable en raison de l'état de surface de ses faces supérieure et inférieure, lesquelles sont extrêmement polies.

Le matériau électriquement isolant (diélectrique) de la couche d'isolant 12 peut être du dioxyde de silicium (SiO2), par exemple. Des couches minces de dioxyde de silicium se développent spontanément sur les wafers de silicium, par oxydation thermique, en donnant une couche très fine d'environ 1 nm d'oxyde natif. La couche 12 peut dès lors être obtenue en faisant croître une couche de dioxyde de silicium à partir de cette fine couche d'oxyde natif, par exemple en chauffant la plaquette à des températures comprises entre 600 et 1200 °C, en présence d'oxygène (oxydation sèche) ou d'eau (oxydation humide), selon l'une ou l'autre des réactions chimiques suivantes, respectivement :
- Si + O2 -> SiO2 ; ou bien,
- Si + 2 H2O -> SiO2 + 2 H2,

L'oxydation humide présente un taux de croissance plus rapide, mais la couche de SiO2 obtenue est moins dense qu'une couche obtenue par oxydation sèche.

La couche de passivation 13 est par exemple une couche en nitrure de Silicium (SiN). Elle a pour fonction de stabiliser l'état de la couche d'isolant 102 après la réalisation de ladite couche, et d'empêcher la contamination de la zone active du substrat, notamment par diffusion de cuivre ou d'eau. La couche 13 de nitrure de silicium peut être déposée par dépôt chimique en phase vapeur à basse pression (LPCVD) ou par dépôt chimique en phase vapeur assisté par plasma (PECVD), puis traitement chimique par acide phosphorique (H3P04). La réalisation de la couche de passivation 13 termine la phase FEOL de la fabrication. Les étapes de fabrication qui suivent appartiennent à la phase BEOL de ladite fabrication.

La phase BEOL de la fabrication commence avec la réalisation du premier niveau de métallisation de la structure d'interconnexion qui est réalisée sur la face avant (face supérieure) de la plaquette 1. En référence à la **figure 3B****,** dans l'exemple très simplifié qui est représenté à cette figure, la structure d'interconnexion ne comprend qu'un unique niveau de métallisation MX consacré à la formation de métallisations horizontales dans une couche 14 de matériau diélectrique. La référence 15 désigne une telle métallisation horizontale, qui est par exemple une piste conductrice s'étendant dans le plan horizontal XY, ici suivant la direction longitudinale X, par exemple pour connecter électriquement entre eux des éléments actifs (non représentés) réalisés dans la couche active du substrat 11 sous-jacent.

Bien entendu, l'invention n'entend être limitée ni par le nombre niveaux de métallisation formés par des couches de d'interconnexion respectives empilées pour contenir des métallisations horizontales comme la piste métallique 15, ni par le nombre ou la configuration de telles pistes, ni bien entendu par leur fonction dans le circuit électronique concerné. Il peut notamment s'agir de pistes conductrices de raccordement électrique entre divers éléments actifs mais également d'éléments passifs comme des inductances, des condensateurs, etc. réalisés sous la forme de motifs en cuivre s'étendant dans un ou plusieurs niveaux de métallisation correspondants de la structure d'interconnexion. Le cas échéant, des métallisations horizontales réalisées dans des niveaux de métallisation horizontale respectifs peuvent être électriquement raccordés ensemble par des métallisations verticales, i.e., des vias. Ces vias sont réalisés dans des niveaux de métallisation verticale intercalés entre les niveaux de métallisation horizontale correspondants.

Les métallisations dans le niveau de métallisation MX présentent une dimension moyenne dans le plan horizontal XY qui est comprise entre quelques dizaines de nanomètres et quelques dizaines de microns, par exemple entre 20nm et 20µm, de préférence entre 200nm et 10µm , et de préférence encore entre 800nm et 5µm, par exemple de l'ordre de 1µm ou 2µm.

Le procédé selon l'invention comprend des étapes permettant de réaliser la liaison de la plaquette 1, en tant que plaquette supérieure par exemple, avec une autre plaquette 2 qui est alors une plaquette inférieure dans cet exemple, après retournement vertical et collage hybride de ladite plaquette supérieure 1 sur ladite plaquette inférieure 2. Par cette liaison, les plaquettes supérieure et inférieure sont liées mécaniquement par l'effet des forces de Van der Waals et sont en même temps raccordées électriquement l'une à l'autre, par des plots de liaison non-fonctionnels (plots de collage seulement) et par des plots de liaison fonctionnels (plots de collage et de raccordement électrique), respectivement. Conformément à des modes de mise en oeuvre de l'invention, la structure de liaison assurant cette double fonction ne comprend qu'un seul niveau de métallisation uniquement, noté HBM (mis pour « *Hybrid Bonding Metal* » en anglais), au lieu de à la fois le niveau de métallisation horizontale HBM et le niveau de métallisation verticale HBV prévus dans les réalisations conformes à l'art antérieur qui sont illustrées par les figures 1A-1D décrites plus haut, dans lesquelles le niveau HBV comporte les vias qui assurent le raccordement électrique des plots de liaison fonctionnels à des métallisations horizontales formées dans des couches de métallisation horizontale plus basses.

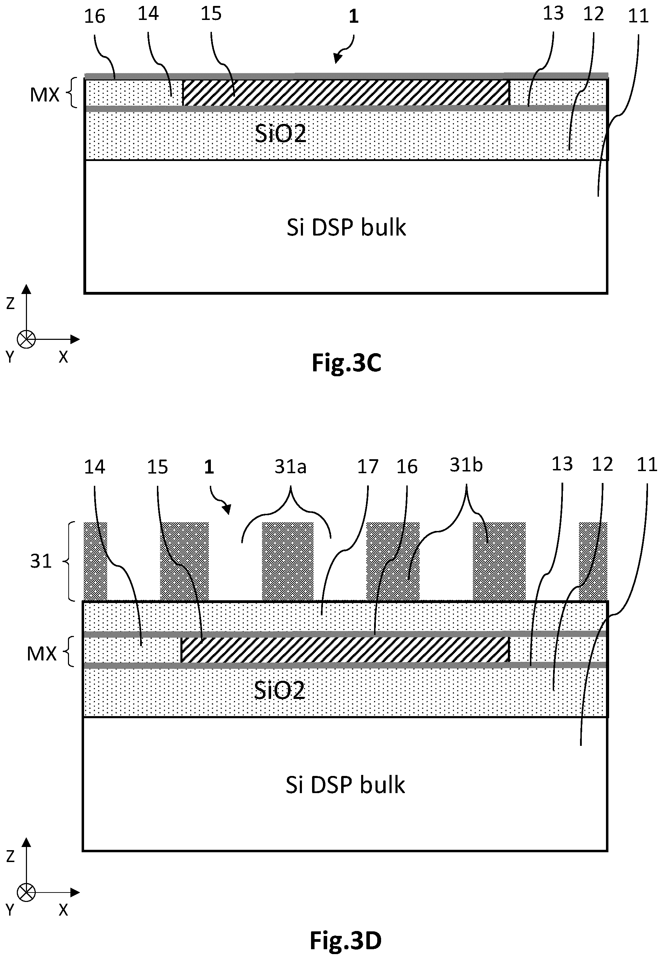

Lors d'une première étape (étape 1), illustrée par le bloc 41 du diagramme de la **figure 4****,** on forme une couche de passivation 16 par-dessus la couche 14 correspondant le cas échéant (c'est-à-dire lorsqu'il existe plusieurs niveaux de métallisation empilés verticalement) au niveau de métallisation horizontale MX le plus haut, dans lequel sont réalisés des métallisations horizontales d'interconnexion des composants actifs et/ou des composants passifs du circuit électronique. Le résultat de l'étape 1 est représenté à la **figure 3C****.**

La couche de passivation 16 est par exemple une couche en nitrure de Silicium (SiN) ou en carbonitrure de silicium (SiCN). Elle permet de stabiliser l'état du dioxyde de silicium (SiO2) du niveau de métallisation MX, i.e., de ralentir notablement sa vitesse de corrosion c'est-à-dire sa vitesse d'oxydation naturelle, et de prévenir la formation de rayures à la surface des pistes conductrices en cuivre. Elle permet aussi de protéger les métallisations comme la piste conductrice 15 contre les micros-rayures lors des manipulations de la plaquette d'un poste de traitement à un autre dans la salle blanche. Une fine couche de nitrure de silicium 16 (de l'ordre de 200 nm par exemple) peut être formée par un dépôt chimique en phase vapeur (CVD) impliquant des mélanges de gaz tels que Si/NH4, SiCl4/NH3 ou encore SiH2Cl2/NH3, et traitement chimique par acide phosphorique (H3P04). Le dépôt par CVD peut être un dépôt chimique en phase vapeur basse pression (LPCVD) qui fonctionne à température relativement élevée (entre 700 et 900°C, de l'ordre de 775°C par exemple). En variante, la couche de passivation 16 en nitrure de silicium peut être formée par dépôt chimique en phase vapeur assisté par plasma (PECVD), qui est opéré à température relativement modérée (entre 200 et 350°C, de l'ordre de 200°C par exemple) et sous vide. Dans un exemple, la couche 16 de nitrure de silicium peut avoir une épaisseur de 50 nm, environ.

En référence à la **figure 4****,** un groupe 42 d'étapes suivantes est alors mis en oeuvre, pour arriver à la microstructure illustrée par la **figure 3D****.** Les étapes de ce groupe d'étapes 42 comprennent les étapes 2, 3 et 4 du procédé, qui sont mises en oeuvre successivement et dans cet ordre.

A l'étape 2 du procédé, on réalise le dépôt conforme d'une couche 17 de TEOS (mis pour tetraethylorthosilicate, en abrégé) sur la face supérieure de la microstructure de la figure 3C. Le TEOS, de son vrai nom "orthosilicate de tétraéthyle" et de formule chimique Si(OCH2CH3)4 ou plus simplement Si(OEt)4, est utilisé comme précurseur du dioxyde de silicium (SiO2).

A l'étape 3 du procédé, on effectue un recuit c'est-à-dire qu'on chauffe la microstructure revêtue de la couche conforme de TEOS, à une température par exemple de 400°C environ, pour transformer la couche 17 de TEOS en une couche de dioxyde de silicium (SiO2). Dans un exemple, la couche 17 d'oxyde de silicium ainsi formée peut avoir une épaisseur de 900 nm, environ. Cette couche 17 agit comme isolant électrique. Elle peut en effet bloquer le courant électrique depuis ou vers les métallisations réalisées dans la couche 14 sous-jacente de la structure d'interconnexion.

La personne du métier appréciera qu'il existe d'autres moyens de réaliser la couche de diélectrique 17, mais la couche obtenue comme proposé dans ce qui précède (avec les étapes 2 et 3 ci-dessus) a l'avantage de présenter une grande stabilité chimique.

A l'étape 4, on forme un masque 31 de résine photosensible ou "photo-résine" (« *photoresist* », en anglais), afin d'obtenir un revêtement protecteur à la surface de la microstructure, en vue de l'exécution d'une première opération de photolithographie 5 (notée "HBM 1" à la figure 4 et dans la suite), à exécuter pour réaliser le niveau de métallisation HBM avec des plots de liaison de liaison non-fonctionnels 17b et des plots de liaison fonctionnels 17c pour le collage hybride. Cette photolithographie HBM 1 vise à réaliser un masque par gravure de la couche 17 d'oxyde de silicium à travers le masque de photo-résine 31, lequel masque pourra ensuite être utilisé pour ouvrir la couche de nitrure de silicium 16 afin d'exposer les portions des métallisations de la couche MX destinées à être raccordées électriquement aux plots de liaison fonctionnels 17c.

Plus particulièrement, l'étape 4 comprend :
- l'étalement (« *spreading* ») de la photo-résine, par exemple par un procédé d'enduction centrifuge (« spin *coating* », en anglais), dont le principe consiste à étaler sur la plaquette à l'aide de forces centrifuges une petite quantité de résine mélangée à un solvant qui lui donne temporairement une certaine fluidité, et placée au centre de la plaquette avant sa mise en rotation ; puis le développement de la photo-résine qui inclut
- l'exposition de ladite résine à un rayonnement optique, par exemple un rayonnement dans le domaine ultraviolet (UV), à travers un masque optique ad-hoc. Un tel masque comprend des zones opaques et des zones transparentes, qui définissent les motifs de gravure, soit en positif soit en négatif selon la nature de la photo-résine considérée. Il permet de définir les motifs que l'on souhaite reproduire sur la plaquette 1, dans la couche 17 de SiO2, par gravure à travers la couche de résine ainsi développée qui forme un masque de gravure ; et,
- le retrait sélectif, par exemple par voie chimique (« *chemical etching* » en anglais) des portions de résine exposées, ou au contraire des portions de résine non-exposées, selon la nature (positive ou négative) de la photo-résine. Le procédé de retrait mis en oeuvre peut être un retrait chimique en phase vapeur, par exemple sous plasma d'oxygène, qui permet de nettoyer de façon très propre toute trace de matériaux organiques tels que les résines photosensibles.

Le masque optique utilisé pour révéler la photo-résine de la couche 31 à l'étape 4 présente des motifs qui correspondent au schéma d'implantation des plots de liaison pour le collage hybride, en ce compris les plots de liaison non-fonctionnels 17c ainsi que les plots fonctionnels 17b. Dit autrement, la première lithographie HBM 1 permet de former, dans la couche 17 en matériau diélectrique, les caissons 17a dans lesquels seront ensuite réalisés tous les plots de liaison en métal pour le collage hybride la plaquette 1 sur l'autre plaquette 2, qu'il soient fonctionnels ou non-fonctionnels, c'est-à-dire qu'ils servent au collage uniquement, ou bien à la fois au collage et au raccordement électrique, respectivement, entre les deux plaquettes 1 et 2.

Il n'apparaît pas nécessaire de détailler plus avant les sous-étapes ci-dessus de l'étape 4 qui permettent d'obtenir le masque de la photolithographie HBM 1 (dit aussi masque HBM 1 par raccourci), qui sont bien connues en elles-mêmes de la personne de métier.

A l'issue du groupe d'étapes 42 comprenant les étapes 2, 3 et 4 présentées ci-dessus, le masque en photo-résine 31 est tel que montré à la figure 3D déjà mentionnée. Dans la configuration de la figure 3D, le masque HBM 1 expose la couche 17 seulement à travers ses zones ouvertes 31a (ou ouvertures), et il masque la couche 17 en dehors desdites zones 31a.

A l'étape 5, qui fait partie du groupe des étapes 5 et 6 figuré par le bloc 43 de l'organigramme de la figure 4, on procède à la gravure de la couche 17 de matériau diélectrique (SiO2) à travers le masque HBM 1, avec arrêt sur la couche 16 de nitrure de silicium.

Il peut s'agir d'une gravure chimique (ou gravure humide) par une solution à base d'acide fluorhydrique (HF) par exemple, ou d'une gravure physique (ou gravure sèche), c'est-à-dire une gravure par plasma. La gravure peut aussi être une gravure ionique réactive (ou RIE, de l'anglais « *Reactive Ion Etching* »), qui est une variation de la gravure par plasma combinant la sélectivité des gravures chimiques et l'anisotropie des gravures physiques. Dans des modes de mise en oeuvre, le plasma peut alors être un plasma fluoro-carboné, à base d'un gaz tel que le tétrafluorure de carbone (CF4) par exemple, ou à base d'hexafluorure de soufre (SF6) ou encore à base de trifluorure d'azote (NF3), ou de toute combinaison de ces gaz. La couche 17 de matériau isolant, partiellement protégée par le masque de gravure HBM 1 formé par la couche 31 de dioxyde de silicium partiellement ouverte comme exposé dans ce qui précède, est placé dans une chambre dans laquelle on fait le vide. Cette chambre est munie de deux électrodes horizontales et parallèles, l'électrode inférieure servant de plateau pour recevoir la plaquette 1. Une fois que le vide dans la chambre a été fait, le gaz y est introduit. Puis un fort champ électrique en radiofréquence (RF), par exemple d'une centaine de volts par mètre ou plus, est appliqué à l'électrode inférieure. Ceci génère dans la chambre un plasma, c'est-à-dire un gaz en partie ionisé. En effet, certains électrons des molécules de gaz sont arrachés par le champ électrique, ce qui ionise lesdites molécules. La face supérieure de la plaquette subit alors un bombardement d'ions qui la désagrège.

L'avantage d'une telle gravure est qu'elle est fortement anisotrope, le bombardement d'ions s'effectuant uniquement suivant la direction entre les électrodes, i.e., la direction normale au plan de la plaquette 1. La frontière entre les zones gravées et les zones non gravées est donc bien rectiligne et verticale. Mais cette gravure est peu sélective, c'est-à-dire qu'elle détruit le matériau du masque HBM 1 formé par la couche 31 en même temps que les zones de la couche protectrice 17 sous-jacente qui sont exposées par les ouvertures 31a à travers ledit masque. La gravure est achevée lorsque le Nitrure de Silicium (SiN) de la couche 16 est atteint au niveau des ouvertures 31a du masque HBM 1.

A l'étape 6, on effectue le retrait (« stripping » en anglais) des résidus de la résine du masque HBM 1. Ceci peut être effectué par gravure chimique, par exemple avec une solution à base d'acide sulfurique (H2SO4) et de peroxyde d'hydrogène ou eau oxygénée (H2O2).

On notera que même si l'étape de gravure 5 laisse la surface du masque HBM 1 relativement endommagée, ceci n'est pas un réel inconvénient dès lors que, à l'étape 6 qui suit l'achèvement de la gravure, les résidus du masque de gravure HBM 1 sont retirés. Pour limiter le risque de destruction du masque avant la fin de la gravure, on peut interrompre temporairement le bombardement ionique de l'étape 5 en cours de gravure, pour faire recuire la plaquette (« *annealing* » en anglais) afin de redurcir le masque HBM 1 par reformation du réseau cristallin de la couche 31, avant de reprendre la gravure par bombardement ionique. Ce processus peut éventuellement être répété plusieurs fois à la suite, jusqu'à l'achèvement de la gravure, i.e., jusqu'à atteindre la couche de Nitrure de Silicium 16.

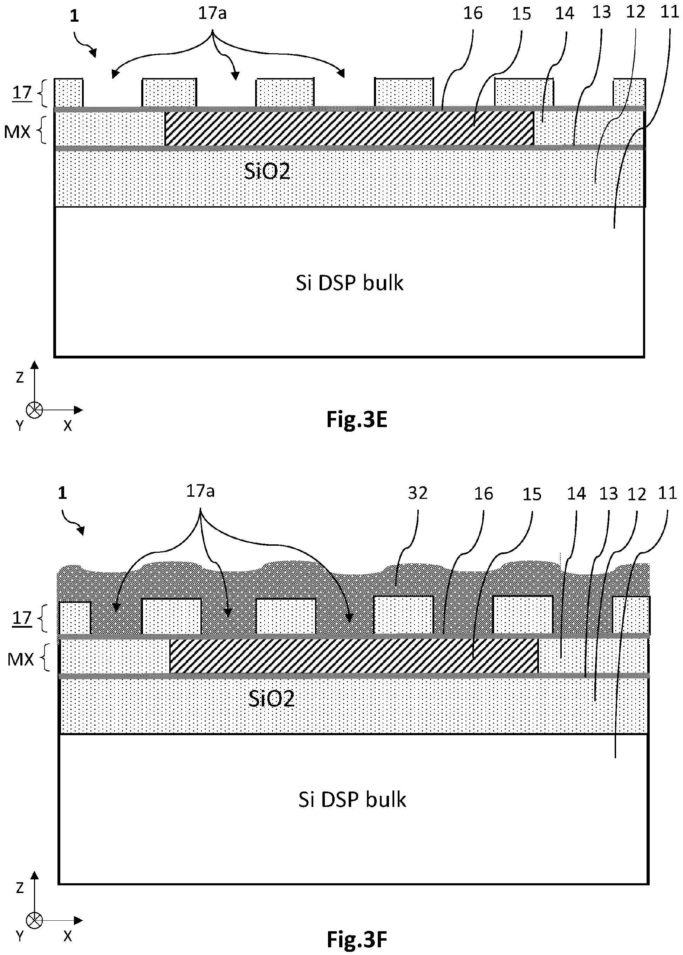

A l'issue du groupe d'étapes 43 comprenant les étapes 5 et 6 présentées ci-dessus, la microstructure est telle que montrée à la **figure 3E****.**

A l'étape 7, qui constitue la seule étape du bloc 44 du diagramme d'étapes de la figure 4, on étale une nouvelle couche de photo-résine 32 destinée à former un masque de gravure, en vue de l'exécution d'une seconde lithographie notée "HBM 2". En référence à la figure 3F, la couche de photo-résine 32 est déposée de manière conforme sur la face avant de la plaquette, par exemple par enduction centrifuge (voir plus haut, à propos de la couche de photo-résine 31 pour former le masque de gravure HBM 1). Ainsi qu'on peut le voir sur cette figure, la couche 32 épouse le relief qui résulte des ouvertures 17a formée dans la couche de matériau diélectrique 17 par la première lithographie HBM 1. Dit autrement, ladite couche 17 a une épaisseur telle que la face libre de cette couche suit de manière conforme les creux et/ou les saillies de la microstructure sur laquelle elle est déposée.

La photo-résine de la couche 32 est ensuite développée à l'étape 7a pour former un nouveau masque de gravure, lequel est ensuite utilisé pour exécuter une seconde lithographie, dite "HBM 2". Cette lithographie HBM 2 est ensuite exécutée à l'étape 8 pour graver la couche 15 de Nitrure de Silicium. Dans ce qui suit et dans les figures des dessins, ce masque est dit "masque HBM 2" par raccourci.

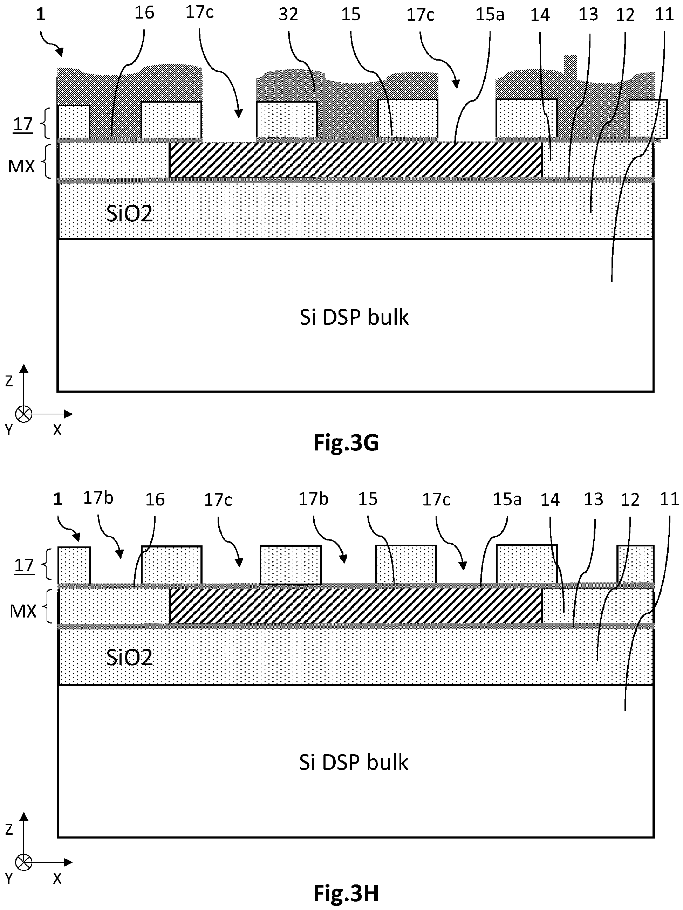

Dans le diagramme d'étapes de la figure 4, les étapes 7a et 8 sont regroupées dans le bloc d'étapes 45, car le résultat global obtenu après exécution de ces deux étapes est montré à la **figure 3G****.**

Comme montré sur cette figure, le masque optique utilisé pour révéler la photo-résine de la couche 32 à l'étape 7a présente des motifs qui correspondent au schéma d'implantation des plots de liaison fonctionnels 17c. En d'autres termes, le masque optique utilisé pour révéler la photo-résine de la couche 32 à l'étape 7a présente des motifs qui correspondent aux motifs d'interconnexion définis par le schéma d'implantation des plots de liaison fonctionnels 17c qui sont destinés au raccordement électrique de la plaquette 1 avec l'autre plaquette 2, par le collage hybride desdites plaquettes 1 et 2. Dit autrement, encore, la seconde lithographie HBM 2 permet d'ouvrir le fond de certains caissons 17c parmi les caissons 17a ayant été formés dans la couche 17 en matériau diélectrique par la première lithographie HBM 1.

Ce résultat est obtenu à l'étape 8 en gravant partiellement la couche de Nitrure de Silicium 16 au fond desdits caissons 17c seulement, à travers le masque de gravure HBM 2. Par cette ouverture partielle de la couche 16 à l'étape de gravure 8, on expose au fond des caissons 17c le métal de certaines des métallisations horizontales du niveau de métallisation MX dans la couche diélectrique 14, comme la piste conductrice 15 dans l'exemple montré à la figure 3G. Comme on l'aura compris, il s'agit des métallisations qui, selon le plan de routage du dispositif microélectronique 3D, ont besoin d'être reprises à l'interface de collage entre les plaquettes 1 et 2. Les plots de liaison fonctionnels 17c peuvent ensuite être formés en remplissant les caissons 17c de métal, avec couplage c'est-à-dire avec continuité électrique jusqu'à des métallisations horizontales du niveau de métallisation MX, en vue d'assurer le raccordement électrique souhaité entre les deux plaquettes 1 et 2. Bien entendu, en plus d'assurer ce raccordement électrique, les plots fonctionnels 17c ainsi réalisé peuvent servir de support pour le collage hybride desdites plaquettes.

Les autres caissons 17b parmi les caissons 17a formés par la première lithographie HBM 1, i.e., les caissons autres que les caisson 17c précités, ne sont pas ouverts jusqu'au métal de la couche hybride 14 par l'exécution de la gravure 8 correspondant à la seconde lithographie HBM 2. La couche de Nitrure de Silicium 16 y est laissée intacte, étant protégée par le masque de gravure HBM 2. Ces autres caissons 17b sont ceux dans lesquels les plots de liaison non-fonctionnels seront ensuite réalisés par dépôt de métal, sans couplage c'est-à-dire sans continuité électrique avec le métal des métallisations horizontales du niveau de métallisation MX. L'isolation électrique entre les plots de liaison non-fonctionnels 17b et toute métallisation horizontale du niveau de métallisation MX dans la couche hybride 14 est assurée par la couche de Nitrure de Silicium 16 (matériau isolant) qui demeure intacte au fond des caissons 17b à l'issue de la gravure exécutée à l'étape 8 à travers le masque de gravure HBM 2.

La gravure du Nitrure de Silicium de la couche 16 exécutée à l'étape 8 à travers le masque de gravure HBM 2 peut, comme la gravure de la première lithographie, être une gravure ionique réactive (RIE), avec un plasma fluoro-carboné, par exemple à base d'un gaz tel que le tétrafluorure de carbone (CF4) et/ou l'hexafluorure de soufre (SF6) et/ou le trifluorure d'azote (NF3).

A l'étape 9 on effectue le retrait du matériau du masque de photolithographie HBM2. Comme pour le retrait des résidus de résine du masque de gravure HBM 1 à l'étape 6, ce retrait peut être obtenu par une gravure chimique avec une solution d'acide sulfurique (H2SO4) et de peroxyde d'hydrogène (H2O2). A l'issue de ce retrait, qui est figuré par le bloc 46 dans le diagramme d'étapes de la figure 4, on obtient la microstructure illustrée par la **figure 3H****.**

Il convient ensuite de procéder au dépôt conforme d'une couche de cuivre afin de remplir les caissons 17c pour former les plots fonctionnels 17c, ainsi que les caissons 17c pour former les plots non-fonctionnels 17b. Avantageusement une seule et même étape de dépôt assure la formation simultanément de tous les plots de liaison, à savoir les plots de liaison non-fonctionnels 17b et les plots de liaison fonctionnels 17c. Ce dépôt peut être obtenu, par exemple, par un procédé de dépôt électrochimique (ECD). C'est l'objet des étapes 10,11, 12 et 13 qui vont maintenant être présentées. Ces étapes font partie du groupe d'étapes représenté par le bloc 47 dans le diagramme d'étapes de la figure 4.

Dans cet exemple, le remplissage avec du cuivre des caissons 17c et 17b pour réaliser les plots de liaison fonctionnels 17c et les plots de liaison non-fonctionnels 17b, respectivement, s'effectue en deux étapes. Ce mode de mise en oeuvre en deux étapes permet de pallier les problèmes d'uniformité du dépôt du cuivre, qui résultent notamment des écarts les résistivités respectives des matériaux présents sur la surface à recouvrir : la résistivité de la couche 17 en Dioxyde de Silicium (SiO2) est généralement comprise entre 10¹² et 10¹⁶ ohms centimètre (Ω cm) et la résistivité de la couche 16 en Nitrure de Silicium (SiN) qui est exposée dans le fond des caissons 17b est de l'ordre de 10¹⁶ Ω cm, alors que la résistivité des métallisations horizontales du niveau de métallisation MX qui sont exposées dans le fond des caissons 17c est de 17×10⁻⁷ Ω cm, soit 1,7 µΩ cm, Dans une première étape, on dépose un film de cuivre, à savoir une couche fine de cuivre adaptée pour bien tapisser tout l'intérieur des caissons 17c et 17b à remplir, et pour servir de sous-couche de cuivre. Cette couche fine joue ensuite le rôle de couche d'accroche dite aussi film de germination (appelée « *seed layer* » en anglais), pour la croissance d'une couche plus épaisse de cuivre massif, par exemple par ECD.

Pour le dépôt électrochimique, on immerge la plaquette dans une solution électrolytique comprenant des ions précurseurs du cuivre, la plaquette 1 (et donc en particulier la couche d'accroche en cuivre) étant configurée comme une cathode, *i.e*., en borne négative. En variante ou en complément, le cuivre est déposé sur la couche d'accroche à partir d'une source de cuivre configurée en anode, *i.e*., en borne positive, lorsqu'on fait circuler un courant électrique entre lesdites bornes positive et négative. Dans tous les cas, la réaction de dépôt électrochimique étant une réaction pilotée par un courant électrique, elle est très sensible à la chute ohmique au niveau de la surface à revêtir. Pour éviter tout risque de formation de vides dans les motifs formés des caissons 17b et 17c pendant leur remplissage par voie électrochimique, il est donc idéal d'avoir préalablement formé une couche d'accroche parfaitement conforme, c'est-à-dire d'épaisseur la plus constante possible tout en épousant l'ensemble des creux et/ou des saillies qui existent en surface de la microstructure. Ceci favorise le remplissage du fond des caissons 17b et 17c, et empêche lesdits caissons de se refermer prématurément en créant une cavité en leur sein. Il sortirait du cadre de la présente description d'exposer les étapes technologiques permettant d'atteindre ce résultat. La personne du métier, sur la base de ses connaissances générales, saura se référer en tant que de besoin à la littérature technique correspondante, concernant notamment mais pas uniquement les techniques de dépôt dit "super-conforme" (« *super-fill* » en anglais), par exemple.

En pratique et en référence au diagramme d'étapes de la figure 4, à l'étape 10 on effectue tout d'abord le dépôt sur la microstructure d'une sous-couche de cuivre très fine par dépôt physique en phase vapeur (ou PVD, de l'anglais « *Physical Vapor Deposition* ») à basse et moyenne température, ou par dépôt chimique en phase vapeur (ou CVD, de l'anglais « *Chemical Vapor Déposition* ») à moyenne et haute température, pour former la couche de germination du cuivre.

Ce dépôt chimique est obtenu en présence d'une solution contenant un précurseur (« *seed* » en anglais) du métal à déposer. Le précurseur d'un métal comprend majoritairement des ions de ce métal. Plutôt qu'un revêtement monolithique, on peut avoir avantage à réaliser la couche d'accroche comme un film en un alliage combinant différents matériaux apportant chacun leurs avantages respectifs (adhérence, point de fusion, densité, coefficient de dilatation thermique, résistivité électrique, etc.). Le comportement des précurseurs lors du dépôt (volatilité, pression de vapeur, stabilité, etc.) est aussi un critère de sélection du (ou des) ion(s) précurseur(s). En résumé, les composés ioniques du groupe de matériaux considéré pour former le film de germination sont sélectionnés en prenant en compte des critères thermodynamiques, mécaniques et physiques. Dans l'application concernée par l'invention, à savoir le remplissage avec du cuivre des motifs de liaison dans le niveau de métallisation HBM des plaquettes à assembler par collage hybride, un système Ti-TiN-Cu se révèle être un bon candidat pour le dépôt de cuivre en phase vapeur, physique ou chimique. La solution correspondante comprend majoritairement des ions cuivre, ainsi que des ions titane et des ions de nitrure de titane.

En variante d'un procédé PVD ou CVD, la couche d'accroche peut être formée par réduction d'une solution de précurseurs ioniques du cuivre et le cas échéant des autres métaux sélectionnés pour composer un alliage cuivrique. Afin de favoriser le dépôt conforme, il peut en effet être choisi de passer par la formation d'un oxyde et notamment d'un oxyde de cuivre seulement, plus favorable thermodynamiquement que la formation de cuivre métallique, puis de réduire cet oxyde par exemple lors d'un recuit sous atmosphère réductrice.

Dans tous les modes de mise en oeuvre, l'épaisseur de la couche de germination de cuivre qui est déposée est de quelques dizaines de nanomètres. Comme exposé plus haut, cette couche d'accroche a pour fonction d'initier la croissance électrolytique du cuivre lors de la mise en oeuvre d'un procédé de dépôt électrolytique (ECD) du cuivre. Dans des exemples de mise en oeuvre, l'épaisseur de la couche d'accroche peut être d'environ 90 nm.

A l'étape 11, on effectue le dépôt de la couche de cuivre massif proprement dit, par exemple par procédé ECD. Ceci est réalisé, par exemple, en plongeant la plaquette dans l'électrolyte et en appliquant une tension entre la plaquette configurée en cathode et une anode, par exemple une source de cuivre configurée en anode. Les motifs correspondants aux caissons 17b et 17c déjà recouvert du film de germination sont alors remplis de cuivre par voie électrochimique.

Pour que le remplissage des motifs se fasse de façon conforme, plusieurs additifs peuvent être ajoutés à l'électrolyte : un suppresseur, un accélérateur et un nivelant. Ces additifs, détaillés ci-dessous, combinent leurs effets pour ralentir le dépôt en haut de tranchée et l'accélérer en bas de tranchée :
- les suppresseurs sont des macromolécules, comme par exemple le polyéthylène glycol (PEG), ayant tendance à rester en surface de la microstructure sans diffuser dans les tranchées, qui réagissent avec des chlorures ajoutés en solution, pour former un film protégeant la surface et limitant la réduction du métal à cet endroit ;
- les accélérateurs inhibent l'effet des suppresseurs, tout en ayant tendance à se placer dans les tranchées. Ils permettent donc la croissance du cuivre dans les tranchées. Les accélérateurs sont souvent des molécules sulfurées dont le SPS (HSO3(CH2)3S) est un exemple non limitatif ; et,
- les nivelants, tel que la molécule JGB (Janus Green B), ont le même type d'action que les suppresseurs, mais ont tendance à se placer dans les zones de forte densité de courant (pics, protubérances...). Ils permettent donc de limiter le dépôt dans les points hauts de la microstructure.

Pour achever le dépôt de cuivre par le procédé ECD, on peut effectuer à l'étape 12 un recuit de stabilisation à haute température pour provoquer la fusion à l'interface de dépôt. On obtient ainsi des interfaces moins abruptes, donc moins fragiles. Ce recuit permet aussi de stabiliser la couche de Cu. Par exemple, un recuit à 400 °C permet à la microstructure d'atteindre l'équilibre thermodynamique.

La personne de métier appréciera que, à la place de l'électrodéposition (ECD), on peut aussi bien utiliser un autre procédé de dépôt de métal, i.e., un procédé différent pour le dépôt du cuivre massif. En variante du procédé ECD décrit ci-dessus, on peut par exemple choisir une technique parmi une transformation autocatalytique, une précipitation, une cristallisation, une réticulation, une agrégation, ou autre.

Dans ce qui précède, on a proposé des modes de réalisation dans lesquels le métal de remplissage des caissons 17b et 17c pour former simultanément les plots de liaison 17b et 17c, respectivement, est du cuivre. L'invention n'est toutefois pas limitée à cet exemple. Un autre métal peut être déposé dans les caissons pour former les plots de liaison, par exemple de l'or (Au), qui peut également être déposé par électrodéposition (ECD) à partir d'un précurseur chimique comprenant des ions métalliques correspondants, ou du titane (Ti), de l'aluminium (Al), du niobium (Nb), ou du platine (Pt), qui peuvent alors être déposé de préférence par un procédé de type PVD. Cette liste d'exemples de métaux n'est pas limitative. Le cas échéant, une couche d'accroche (film de germination) adaptée à la croissance de ce métal est alors formée à l'étape 10.

A l'étape 13, le surplus de cuivre est retiré à la surface supérieure du niveau de métallisation HBM, par exemple par un processus de polissage mécano-chimique (CMP). Le processus CMP un niveau très fin de nano-topographie (inférieur à 5 nm, par exemple) et garantit un très faible niveau de rugosité (inférieur à 0,5 nm, par exemple) pour un collage hybride sans défauts. Dit autrement, la mise en oeuvre de l'étape 13 donne une plaquette 1 dont la surface supérieure est ultra-polie. L'étape 13 termine le groupe d'étapes représenté par le bloc 47 dans le diagramme d'étapes de la figure 4. On obtient alors la microstructure 1 montrée à la **figure 3I****.**

A l'étape 14, on procède au collage hydride sur la plaquette inférieure 2, de la plaquette supérieure 1 après retournement vertical de celle-ci. Bien entendu, la plaquette inférieure 2 a subi les mêmes traitements que la plaquette supérieure 1, parallèlement. Elle possède donc une structure d'interconnexion présentant les mêmes caractéristiques que la plaquette supérieure 1. Sa surface supérieure est également ultra-polie. Le collage est direct - sans colle - et s'effectue à température ambiante. Cela évite le risque de dégradation et d'interaction non désirée d'un adhésif lors d'un traitement en température ultérieur, le cas échéant.

A l'étape 15 on peut effectuer un recuit de collage de la microstructure 3D obtenue, afin de renforcer l'interface de collage 60 entre les plaquettes 1 et 2, et assurer la connexion électrique entre les plots de collage fonctionnels 17c et 27c des plaquettes 1 et 2, respectivement. Par exemple, on peut effectuer un recuit de collage à 400 °C pendant deux heures. Pour évaluer la qualité du collage, la microscopie acoustique à balayage (SAM, de l'anglais « Scanning *Acoustic Microscope* ») peut être utilisée afin de détecter des vides (« *voids* »), le cas échéant.

De façon connue en soi, le substrat arrière 11 de la plaque supérieure 1 est finalement aminci, par exemple par un processus effectué depuis l'avant de la microstructure 3D représentée à la figure 2, par exemple d'abord mécaniquement puis ensuite chimiquement afin de réduire le risque d'endommagement de l'interface de collage 60.

Dans le diagramme d'étapes de la figure 4, les étapes 14 et 15 sont regroupées dans le bloc 48. Le résultat obtenu à l'issue de ce groupe d'étapes 48 est la microstructure 3D de la figure 2.

Le tableau de la **figure 5** liste les étapes de la réalisation de la microstructure 3D selon des mises en oeuvre du procédé selon l'invention (colonne de droite) pour réaliser la microstructure 3D de la figure 2 dans laquelle le niveau d'interconnexion supérieur HBM de la structure d'interconnexion de la plaquette est directement au-dessus du niveau d'interconnexion horizontale MX, en les rapprochant des étapes d'un procédé conforme à l'art antérieur (colonne de gauche) pour réaliser la microstructure 3D classique de la figure 1C, c'est-à-dire ayant un niveau d'interconnexion verticale HBV avec des métallisations verticales (des vias) entre le niveau d'interconnexion supérieur HBM et le niveau d'interconnexion horizontale MX.

Comme la personne de métier peut s'en apercevoir, on supprime neuf étapes technologiques de réalisation, ce qui est un gain significatif en termes de bilan énergétique notamment, ainsi également qu'en termes de temps de traitement en salle blanche.

En outre, en supprimant le niveau de métallisation HBV des microstructures 3D de l'art antérieur, on supprime deux couches de matériau diélectrique (une dans chacune des plaquettes supérieure et inférieure empilées par collage hybride), en l'occurrence deux couches de Dioxyde de Silicium (Si02), ce qui est un progrès en termes de contraintes mécaniques. On supprime également deux couches d'isolant, à savoir la couche d'isolant en Nitrure de Silicium (SiN) recouvrant la couche de matériau diélectrique du niveau de métallisation HBV des plaquettes supérieure et inférieure des microstructures 3D conformes à l'art antérieur.

Des modes de réalisation particuliers viennent d'être décrits. Différentes variantes et modifications apparaîtront à l'homme du métier. Notamment, il va sans dire que l'invention n'est pas limitée par le nombre de niveaux de métallisation prévus dans la structure d'interconnexion, qui peut comporter plusieurs niveaux comme le niveau de métallisation MX considéré ici. En outre, le procédé de réalisation conformément à l'invention d'une microstructure 3D par intégration verticale de plus de deux plaquettes. On peut en effet renouveler les opérations de manière à continuer l'intégration verticale avec le collage, à chaque fois, d'une nouvelle plaquette par-dessus la microstructure obtenue à l'itération précédente, en mettant en oeuvre le procédé de l'invention. Les seules contraintes à cet égard sont celles qui sont, classiquement, relatives à la capacité de reprendre les surfaces afin de les aplanir pour permettre un nouveau collage, et bien sûr à la limite du stress mécanique sur les plaquettes qui est engendré par l'empilement.

## Revendications

1. Structure microélectronique à trois dimensions, 3D, pour un produit semi-conducteur intégré, ladite structure microélectronique 3D comportant un premier dispositif microélectronique réalisé sur une plaquette supérieure (1), ainsi qu'un second dispositif microélectronique réalisé sur une plaquette inférieure (2) sur laquelle la plaquette supérieure (1) est collée par collage hybride après retournement vertical, dans laquelle la plaquette inférieure et la plaquette supérieure comprennent chacune un substrat sensiblement plan ainsi qu'une structure d'interconnexion formée au-dessus dudit substrat, **caractérisée en ce que** :
- la structure d'interconnexion respective de chacune des plaquettes supérieure (1) et inférieure (2) est un empilement vertical d'au moins deux niveaux d'interconnexion directement superposés et comprenant chacun une couche hybride essentiellement composée d'un matériau diélectrique, à savoir, respectivement :
• un niveau d'interconnexion supérieur (HBM), avec des plots de liaison métalliques (17b,17c) formés dans le matériau diélectrique et adaptés pour coopérer avec des plots de liaison métalliques correspondants (27b,27c) de l'autre plaquette pour le collage hybride de la plaquette supérieure (1) sur la plaquette inférieure (2) ; et,
• un niveau d'interconnexion horizontale (MX) qui est directement en-dessous du niveau d'interconnexion supérieur (HBM), avec des éléments de métallisation horizontales (15 ; 25),
- les plots de liaison métalliques respectifs (17b,17c ; 27b,27c) de chacune des plaquettes supérieure (1) et inférieure (2) sont répartis de manière sensiblement homogène à la surface supérieure du niveau d'interconnexion supérieur (HBM) de la structure d'interconnexion de ladite plaquette, avec un pas de collage, défini comme l'espacement maximum entre des plots de liaison adjacents horizontalement dans le plan de ladite surface supérieure, qui est inférieur à un seuil associé déterminé ;
- les plots de liaison métalliques respectifs (17b,17c ; 27b,27c) de chacune des plaquettes supérieure (1) et inférieure (2) comprennent des plots de liaison d'un premier type (17b ; 27b), qui sont isolés électriquement de tout élément de métallisation horizontale (15 ; 25) du niveau d'interconnexion horizontale (MX) de la structure d'interconnexion de ladite plaquette ; et,
- les plots de liaison métalliques respectifs (17b,17c ; 27b,27c) de chacune des plaquettes supérieure (1) et inférieure (2) comprennent en outre des plots de liaison d'un second type (17c ; 27c), qui sont couplés électriquement chacun à au moins un élément de métallisation horizontale (15 ; 25) sous-jacent formé dans le niveau d'interconnexion horizontale (MX) de la structure d'interconnexion de ladite plaquette.

2. Structure microélectronique 3D selon la revendication 1, dans laquelle le niveau d'interconnexion horizontale (MX) de la structure d'interconnexion de chacune des plaquettes inférieure (1) et supérieure (2) comprend un film de passivation (16 ; 26) en matériau électriquement isolant qui recouvre la couche (14 ; 24) en matériau diélectrique dudit niveau de métallisation horizontale (MX), et dans laquelle les plots de liaison du premier type (17b ; 27b) de chacune des plaquettes supérieure (1) et inférieure (2) sont isolés électriquement de tout élément de métallisation horizontale du niveau d'interconnexion horizontale (MX) de la structure d'interconnexion de ladite plaquette, au moins par le matériau isolant du film de passivation recouvrant la couche (14 ; 24) en matériau diélectrique dudit niveau de métallisation horizontale (MX).

3. Structure microélectronique 3D selon la revendication 1 ou la revendication 2, dans laquelle la couche (14 ;24) de matériau diélectrique du niveau d'interconnexion supérieur (HBM) de la structure d'interconnexion de chacune des plaquettes supérieure (1) et inférieure (2) est une couche hybride de matériau diélectrique à motifs, lesdits motifs définissant :
- des zones pleines dudit matériau diélectrique ;
- des premières zones traversantes verticalement emplies de matériau métallique et au niveau desquelles le matériau isolant de la couche de passivation du niveau d'interconnexion horizontale (MX) est présent, lesdites premières zones traversantes formant les plots de liaison du premier type (17b ;27b) du niveau d'interconnexion supérieur (HBM) ; et,
- des secondes zones traversantes verticalement, emplies de matériau métallique, et au niveau desquelles la couche de passivation du niveau d'interconnexion horizontale (MX) présente une ouverture, lesdites secondes zones traversantes formant les plots de liaison du second type (17c ;27c) du niveau d'interconnexion supérieur (HBM), chacun en continuité électrique avec l'un des éléments de métallisation horizontale (15 ;25) du niveau d'interconnexion horizontale (MX) à travers ladite ouverture de la couche de passivation.

4. Structure microélectronique 3D selon l'une quelconque des revendications 1 à 3, dans lequel le seuil associé du pas de collage est inférieur ou égal à 10 µm, de préférence de l'ordre de 5 µm.

5. Structure microélectronique 3D selon l'une quelconque des revendications 1 à 4, dans laquelle le matériau diélectrique des couches hybrides d'interconnexion de la structure d'interconnexion de chacune des plaquettes supérieure (1) et inférieure (2) est du Dioxyde de Silicium (SiO2).

6. Structure microélectronique 3D selon l'une quelconque des revendications 1 à 5, dans laquelle le matériau constitutif des plots de liaison métalliques du niveau d'interconnexion supérieur (HBM) et/ou le matériau constitutif des métallisations horizontales (15,25) du niveau d'interconnexion horizontale (MX) de la structure d'interconnexion de chacune des plaquettes supérieure (1) et inférieure (2), est un métal sélectionné dans le groupe comprenant le cuivre (Cu), l'or (Au), le titane (Ti), l'aluminium (Al), le niobium (Nb) et le platine (Pt), ou un alliage à base de l'un au moins desdits métaux.

7. Structure microélectronique 3D selon l'une quelconque des revendications 2 à 6, dans laquelle le matériau électriquement isolant du film de passivation (16,26) du niveau d'interconnexion horizontale (MX) de la structure d'interconnexion de chacune des plaquettes supérieure (1) et inférieure (2) est un nitrure de Silicium (SiN) ou un carbonitrure de silicium (SiCN).

8. Structure microélectronique 3D selon l'une quelconque des revendications 1 à 7, dans laquelle le substrat de la plaquette supérieure (1) et/ou le substrat de la plaquette inférieure (2) comprennent chacun une zone active avec des éléments actifs dans la partie supérieure dudit substrat, et dans laquelle :
- les plots de liaison du premier type de la structure d'interconnexion de chacune des plaquettes supérieure (1) et inférieure (2) sont électriquement isolés des éléments actifs de la zone active du substrat de ladite plaquette, alors que,
- certains au moins des plots de liaison du second type de la structure d'interconnexion de la plaquette supérieure (1) et/ou de la plaquette inférieure (2) sont couplés électriquement à au moins l'un des éléments actifs de la zone active du substrat de ladite plaquette.

9. Procédé de réalisation d'une structure microélectronique à trois dimensions, 3D, selon l'une quelconque des revendications 1 à 8, comprenant le collage hybride d'une plaquette supérieure (1) sur une plaquette inférieure (2) après retournement vertical de ladite plaquette supérieure (1),
**caractérisé en ce que** la réalisation préalable de la structure d'interconnexion de chacune des plaquettes inférieure (1) et supérieure (2) comprend la formation d'un empilement vertical d'au moins deux niveaux d'interconnexion directement superposés au-dessus du substrat de ladite plaquette, à savoir, respectivement :
- un niveau d'interconnexion horizontale (MX), avec des éléments de métallisation horizontale (15 ; 25) formés dans le matériau diélectrique d'une couche hybride correspondante ; et, directement au-dessus dudit niveau d'interconnexion horizontale (MX),
- un niveau d'interconnexion supérieur (HBM) avec des plots de liaison métalliques (17b,17c) formés dans le matériau diélectrique d'une couche hybride correspondante, et adaptés pour coopérer avec des plots de liaison métalliques correspondants (27b,27c) de l'autre plaquette, pour le collage hybride de la plaquette supérieure (1) sur la plaquette inférieure (2),
ledit procédé étant en outre **caractérisé en ce que** :
- les plots de liaison métalliques respectifs (17b,17c ; 27b,27c) du niveau de métallisation supérieur (HBM) de la structure d'interconnexion de chacune des plaquettes supérieure (1) et inférieure (2) sont réalisés avec une répartition sensiblement homogène à la surface supérieure dudit niveau de métallisation supérieur (HBM), et avec un pas de collage, défini comme l'espacement maximum entre des plots de liaison adjacents horizontalement dans le plan de ladite surface supérieure, qui est inférieur à un seuil associé déterminé ;
- parmi les plots de liaison métalliques respectifs (17b,17c ; 27b,27c) de chacune des plaquettes supérieure (1) et inférieure (2), des plots de liaison d'un premier type (17b ; 27b) sont réalisés chacun avec isolation électrique vis-à-vis de tout élément de métallisation horizontale (15 ; 25) du niveau d'interconnexion horizontale (MX) de la structure d'interconnexion de ladite plaquette ;
- parmi les plots de liaison respectifs (17b, 17c ; 27b,27c) de chacune des plaquettes supérieure (1) et inférieure (2), en outre, des plots de liaison d'un second type (17c ; 27c) sont réalisés chacun en continuité électrique avec au moins un élément de métallisation horizontale (15 ; 25) sous-jacent formé dans le niveau d'interconnexion horizontale (MX) de la structure d'interconnexion de ladite plaquette.

10. Procédé selon la revendication 9, dans lequel la formation du niveau d'interconnexion supérieur (HBM) de la structure d'interconnexion de chacune des plaquettes supérieure (1) et inférieure (2) comprend :
- le dépôt (41) d'un film de passivation (16 ; 26) en matériau électriquement isolant qui recouvre une couche hybride (14 ; 24) en matériau diélectrique comprenant des éléments de métallisation horizontale (15 ; 25) du niveau de métallisation horizontale (MX) de la plaquette ;
- la formation d'une couche (17 ; 27) en matériau diélectrique ainsi qu'une première gravure par photolithographie (41,42), pour graver ladite couche en matériau diélectrique avec arrêt sur le film de passivation (16 ; 26) du niveau de métallisation horizontale (MX) afin de former des motifs dans ladite couche (17 ; 27) en matériau diélectrique correspondant aux plots de liaison métalliques (17b,17c ; 27b,27c) du niveau de métallisation supérieur (HBM) de la plaquette ; puis,
- une seconde gravure par photolithographie (43,44,45), pour graver le film de passivation (16 ; 26) du niveau de métallisation horizontale (MX) afin d'ouvrir ledit film dans une partie seulement des motifs précédemment formés dans la couche (17 ; 27) en matériau diélectrique qui correspondent aux plots de liaison métalliques du second type (17c ; 27c) du niveau de métallisation supérieur (HBM) de la plaquette ; puis,
- le remplissage (47), avec du métal, simultanément de tous les motifs précédemment formés dans la couche (17 ; 27) en matériau diélectrique, à savoir aussi bien les motifs correspondant aux plots de liaison métalliques du premier type (17b ; 27b) que les motifs correspondant aux plots de liaison métalliques du second type (17c ; 27c) du niveau de métallisation supérieur (HBM) de la plaquette.

11. Procédé selon la revendication 10, dans lequel les motifs dans la couche (17 ; 27) en matériau diélectrique correspondant aux plots de liaison métalliques (17b, 17c ; 27b,27c) du niveau de métallisation supérieur (HBM) de la plaquette sont remplis de métal par dépôt électrochimique.
